(19) Europäisches Patentamt / European Patent Office / Office européen des brevets

(11) EP 1 596 250 B1

(12) # EUROPEAN PATENT SPECIFICATION

(45) Date of publication and mention of the grant of the patent:
**15.02.2012 Bulletin 2012/07**

(51) Int Cl.:
***G03F 7/09*** *(2006.01)* ***B41C 1/10*** *(2006.01)*
***G03F 7/16*** *(2006.01)*

(21) Application number: **05010298.7**

(22) Date of filing: **12.05.2005**

(54) **Method of producing photopolymerizable lithographic plate**

Verfahren zur Herstellung von fotopolymerisierbaren lithographischen Druckplatten

Procédé de fabrication de plaques lithographiques photopolymerisables

(84) Designated Contracting States:
**AT BE BG CH CY CZ DE DK EE ES FI FR GB GR HU IE IS IT LI LT LU MC NL PL PT RO SE SI SK TR**

(30) Priority: **12.05.2004 JP 2004142601**

(43) Date of publication of application:
**16.11.2005 Bulletin 2005/46**

(73) Proprietor: **FUJIFILM Corporation**
**Minato-ku**
**Tokyo (JP)**

(72) Inventor: **Kuwabara, Katsushi**
**Haibara-gun**
**Shizuoka (JP)**

(74) Representative: **HOFFMANN EITLE**
**Patent- und Rechtsanwälte**
**Arabellastraße 4**
**81925 München (DE)**

(56) References cited:
**EP-A- 1 450 207** **US-A- 3 458 311**
**US-A1- 2003 008 239**

- **DATABASE WPI Section Ch, Week 200131 Derwent Publications Ltd., London, GB; Class A89, AN 2001-294302 XP002343699 & JP 2001 033975 A (FUJI PHOTO FILM CO LTD) 9 February 2001 (2001-02-09)**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

### BACKGROUND OF THE INVENTION

#### Field of the Invention

The present invention relates to a method of producing a photopolymerizable lithographic plate, in particular, a method of producing a photopolymerizable lithographic plate having an overcoat layer containing, as a main component, a water-soluble polymer containing a hydrogen bond forming group, as well as to a photopolymerizable lithographic plate obtainable by the method.

#### Description of the Related Art

Heretofore, many image forming methods using photopolymerization system have been known and for example, image forming methods using a compound containing an ethylenic double bond which can be polymerized by addition polymerization and a photopolymerization initiator are known. Recently, along with the development of image forming technologies, photopolymers having a high sensitivity to light in the visible region are demanded as a photopolymerizable lithographic plate adoptable to noncontact projection plate making or visible light laser plate making. Here, for the visible light laser, light of 488 nm of Ar+laser and light of 532 nm of YAG-SHG laser can be used.

In such photopolymerization system, high sensitivity is a key factor, and a lot of research and development have been made on photosensitive systems using radical polymerization which is advantageous for achieving high sensitivity. The radical polymerization system, however, is susceptible to inhibition of polymerization by oxygen, and thus there have been some approaches to increase the polymerization efficiency by forming, on the photopolymerization layer, an overcoat layer which contains polyvinyl alcohol (PVA) as a main component and is excellent in oxygen barrier property. Functions required for the overcoat layer mainly include blocking of oxygen, transmission of light and being soluble in developer. Of these functions, the oxygen barrier property is known to be closely related to the oxygen permeation rate of the film, which is generally greatly dependent on the material and the thickness of the overcoat layer. When the oxygen permeation rate is too high, the sensitivity is reduced, and when the oxygen permeation rate is too low, the sensitivity is abnormally increased, unfavorably causing defective development, residual color and residual film. As described above, sensitivity is also affected by properties such as oxygen barrier property of the overcoat layer, and so it often tends to be unstable.

In view of this, the inventors of the present invention proposed a method of producing a photopolymerizable lithographic plate having a stable sensitivity and free of residual color or residual film by controlling the moisture content of the overcoat layer to 4 to 7% to adjust the oxygen permeability of the overcoat layer as in Japanese Patent Application Laid Open No. 2001-33975. To control the moisture content of the overcoat layer to 4 to 7% by weight, the overcoat layer is left in or passed through a humidity-controlled zone of a constant temperature and a constant humidity after being applied on a photopolymerizable layer.

EP 1 450 207 A1 constitutes prior art within the terms of Art. 54(3) and (4) EPC for the present application/ patent insofar as the same contracting states are designated. The document is concerned with a planographic printing plate precursor comprising a protective layer containing an UV absorber. Various materials are stated as being usable in the protective layer including water-soluble polymers such as polyvinyl alcohol.

In US 2003/0008239 A1, an image recoding material is mentioned that may have a protective layer, e.g., of polyvinyl alcohol.

### SUMMARY OF THE INVENTION

However, even if the moisture content of the overcoat layer is set to the target moisture content range of 4 to 7% according to the method of producing a photopolymerizable lithographic plate of Japanese Patent Application Laid Open No. 2001-33975, there have been problems that the developing property and the plate wearing resistance of the photopolymerizable lithographic plate are poor and that such trouble as failure due to minute residual film, failure due to slightly excessive film loss and low transferability in a platesetter may occur.

In addition, there is a problem that the allowable range of the temperature and humidity in the humidity-controlled zone for setting the moisture content of the overcoat layer to the target moisture content range is small, and thus control of the temperature and humidity in the humidity-controlled zone is difficult. For this reason, when the temperature and humidity in the humidity-controlled zone fluctuate because of the change in the temperature and humidity of the outside air due to the change of season or that due to the weather of the day of manufacture, the moisture content of the overcoat layer may go beyond the target range, and complete control of the target moisture content range is difficult. Attempts to cope with this problem in view of production facility require installation of expensive air-conditioning equipment, which

would result in increased facility costs. In particular, in recent high speeding of production line due to increased production efficiency, the time for controlling the moisture content of the overcoat layer in the humidity-controlled zone is shortened, and thus the small allowable range of the temperature and humidity in the humidity-controlled zone makes control of the temperature and humidity even more difficult.

Accordingly, the broader the allowable range of the temperature and humidity in the humidity-controlled zone for setting the moisture content of the overcoat layer to the target range, the easier the control of the temperature and humidity in the humidity-controlled zone, and the less susceptible to the change in the temperature and humidity of the outside air due to the change of season or that due to the weather of the day of manufacture. Thus, manufacturing control would be easier even without expensive air-conditioning equipment, which is extremely advantageous in view of manufacturing technique. Furthermore, it would be easier to correspond to the high speeding of the production line. In addition, although the target moisture content range of the overcoat layer is as small as 4 to 7% by weight in Japanese Patent Application Laid Open No. 2001-33975, manufacturing control would be much easier if high quality photopolymerizable lithographic plates could be obtained even by extending this target moisture content range.

The present invention has been made in view of such circumstances and aims at providing a method which can produce a photopolymerizable lithographic plate having stable sensitivity and excellent qualities without occurrence of failure due to poor plate wearing, failure due to defective development such as residual film or residual color, or bleaching or failure due to residual film caused by a flaw in the overcoat layer, and which can easily and reliably control the moisture content of the overcoat layer without establishing expensive air-conditioning equipment or even in high speed production line.

The inventors of the present invention have found that the stability of sensitivity and plate wearing, and failure due to defective development such as failure due to residual film, which have influence on the quality of a photopolymerizable lithographic plate, are dependent on not only the moisture content which affects the oxygen permeability of the overcoat layer but also the crystallization degree of the overcoat layer, and that a high quality photopolymerizable lithographic plate can be obtained by controlling the crystallization degree of the overcoat layer as set out in present claim 1. Further, another finding is that by controlling the crystallization degree of the overcoat layer, control of the moisture content of the overcoat layer can be facilitated, and various improvements concerning the quality and handling of photopolymerizable lithographic plates can be made, such as mechanical strength of the overcoat layer influential to slightly excessive film loss or minute residual film caused by a flaw in the overcoat layer, adhesion between the overcoat layer and the photopolymerizable layer (photosensitive layer), peeling property of slip sheet from the overcoat layer, and the solubility of the overcoat layer in the developer.

For example, it has been found that when setting the moisture content of the overcoat layer to the target moisture content range, by controlling the moisture content of the overcoat layer after controlling the crystallization degree of the overcoat layer to the range of 0.2 to 0.5, the allowable range of temperature and humidity for achieving the target moisture content range can be extended in the step for controlling moisture content (e.g. humidity-controlled zone).

It has also been found that, by controlling the crystallization degree of the water-soluble polymer of the overcoat layer to 0.2 to 0.5, the water content range of the overcoat layer, which is necessary for ensuring the quality of a photopolymerizable lithographic plate such as stabilization of sensitivity and plate wearing property, prevention of failure due to defective development such as residual film or residual color and prevention of failure due to slightly excessive film loss or minute residual film caused by a flaw in the overcoat layer, can be extended to 2 to 8% by weight, from a conventional range of 4 to 7% by weight described in Japanese Patent Application Laid Open No. 2001-33975.

It has also been found that by controlling the crystallization degree of the overcoat layer to 0.2 to 0.5, various improvements of photopolymerizable lithographic plates can be made, such as improvement in the adhesion between the overcoat layer and the photosensitive layer (photopolymerizable layer), improvement in the solubility of the overcoat layer in a pre-washing solution or alkali developer, and improvement in the property of peeling from slip sheet.

The inventors of the present invention has focused on, as a method of controlling the crystallization degree of the overcoat layer, the fact that the crystallization degree of the water-soluble polymer of the overcoat layer changes depending on the change in the drying condition for drying the overcoat layer. It then has been found that the present invention can be achieved by changing the drying conditions for drying the overcoat layer, such as the temperature, the speed and the dew point of drying air and the drying time, so as to set the crystallization degree to the range of 0.2 to 0.5. The present invention has been substantially established based on these findings.

To achieve the above-mentioned object, the first aspect of the present invention is a method of producing a photopolymerizable lithographic plate having an overcoat layer containing, as a main component, a water-soluble polymer containing a hydrogen bond forming group, the method comprising controlling the crystallization degree (A) of the water-soluble polymer of the overcoat layer in a range of 0.2 to 0.5 as set out in present claim 1.

According to the first aspect, since it is designed to control the crystallization degree of the water-soluble polymer of the overcoat layer, it is possible to improve the stability of sensitivity and plate wearing and failure due to defective development such as residual film or residual color which affect the quality of photopolymerizable lithographic plates. In addition, mechanical strength of the overcoat layer influential to slightly excessive film loss or minute residual

film caused by a flaw in the overcoat layer can be improved. Furthermore, due to the improvement in the adhesion between the overcoat layer and the photosensitive layer (photopolymerizable layer), improvement in the solubility of the overcoat layer in a pre-washing solution or alkali developer, and improvement in the property of peeling from slip sheet, various improvements of photopolymerizable lithographic plates can be made, such as eliminating troubles of carrying slip sheet into the laser exposure section or the development section upon removal of the slip sheet at the platesetter, and improving the transferability in a platesetter of the lithographic plate.

Thereby, the crystallization degree (A) is represented by the following formula

[Equation 1]

$$A = \frac{0.77}{(D1095/D1145)+0.3}$$

in which D1145 is an absorbance at 1145 $cm^{-1}$ which indicates absorption by an OH group having formed a hydrogen bond and D1095 is an absorbance at 1095 $cm^{-1}$ which indicates absorption caused by stretching of a CO group and bending of an OH group in infrared absorption spectroscopy, and wherein the crystallization degree (A) is controlled in a range of 0.2 to 0.5.

The crystallization degree of the water-soluble polymer of the overcoat layer is controlled in a range of 0.2 to 0.5. This is because the crystallization degree is not less than 0.2 for improving the transferability in a platesetter, failure due to slightly excessive film loss and failure due to minute residual film, and because the crystallization degree is not more than 0.5 in view of the stability of sensitivity and plate wearing, and for suppressing the failure due to defective development such as residual film or residual color.

The second aspect is a method according to the first aspect, further comprising, after controlling the crystallization degree, controlling the moisture content of the overcoat layer in a target moisture content range from 2 to 8% by weight based on the total amount of solid components of the overcoat layer.

According to the second aspect, because the moisture content of the overcoat layer is controlled to the target moisture content range after controlling the crystallization degree of the water-soluble polymer of the overcoat layer, the allowable range of the temperature and humidity in the step of controlling the moisture content for achieving the target moisture content range of the overcoat layer can be extended. In addition, by controlling the crystallization degree of the water-soluble polymer of the overcoat layer, the water content range of the overcoat layer can be extended, which is necessary for ensuring the quality of a photopolymerizable lithographic plate, such as stabilization of sensitivity and plate wearing property, prevention of failure due to defective development such as residual film or residual color and prevention of failure due to slightly excessive film loss or minute residual film caused by a flaw in the overcoat layer. The moisture content of the overcoat layer refers to moisture content immediately after a photopolymerizable lithographic plate is produced, and when the web-like photopolymerizable lithographic plate is taken up onto a take-up machine in the form of a roll, it is then referred to as moisture content upon take-up. In addition, after production, when the photopolymerizable lithographic plate is continuously transferred to processing line in which it is cut with laminating a slip sheet without being taken up onto the take-up machine, the moisture content then means one upon contact with slip sheet.

In the second aspect, the moisture content of the overcoat layer is controlled in a target moisture content range from 2 to 8% by weight. Here, the moisture content means weight percent of moisture contained in the overcoat layer based on the total amount of solid components of the overcoat layer.

This defines a preferable moisture content of the overcoat layer when the crystallization degree of the water-soluble polymer of the overcoat layer is controlled to the range of 0.2 to 0.5, and the moisture content is 2 to 8% by weight. According to this, the sensitivity becomes stable and occurrence of failure due to poor plate wearing, failure due to defective development such as residual film or residual color, or bleaching or failure due to residual film caused by a flaw in the overcoat layer can be surely avoided. In addition, because the target moisture content range for ensuring the quality of the photopolymerizable lithographic plate can be extended to 2 to 8% by weight from a conventional range of 4 to 7% by weight (Japanese Patent Application Laid Open No. 2001-33975), manufacturing control is much easier.

The third aspect is a method according to the first or second aspect, wherein the crystallization degree is controlled by adjusting at least one drying condition selected from the group consisting of the temperature, speed, dew point of drying air and drying time where the drying air is used to dry the overcoat layer.

According to the third aspect, because the crystallization degree can be controlled by adjusting the drying condition, no special equipment for controlling the crystallization degree is necessary, and in addition, drying of the overcoat layer and the control of the crystallization degree can be simultaneously conducted. Drying of the overcoat layer may be controlled by combining four factors of the temperature, the speed and the dew point of drying air and the drying time, and of these drying factors, controlling the temperature of the drying air is particularly preferable.

In this regard, the crystallization degree of the overcoat layer may be measured after the crystallization degree is controlled and the drying condition may be adjusted based on the measuring result to conduct feed back control of the crystallization degree.

The fourth aspect is a method according to any one of the first to third aspects, further comprising taking up a web-like raw continuous sheet for the produced photopolymerizable lithographic plate on a take-up machine before said raw sheet is used.

In this aspect, because adhesion between the overcoat layer and the photosensitive layer is improved by controlling the crystallization degree, even if the method of production in which the raw continuous sheet of the produced photopolymerizable lithographic plate is once taken up onto the take-up machine in the form of a roll is conducted, the overcoat layer is hardly peeled off of the photosensitive layer when rolled out, preventing occurrence of failure due to slightly excessive film loss. The present invention is not limited to taking up of the raw continuous sheet of the produced photopolymerizable lithographic plate in the form of a roll on a take-up machine, but applicable to continuous processing in the step of processing sheet for cutting the raw continuous sheet of the produced photopolymerizable lithographic plate with laminating a slip sheet.

The fifth aspect is a method according to any one of the first to fourth aspects, further comprising a sheet processing step for cutting web-like raw continuous sheet for the produced photopolymerizable lithographic plate into a cut sheet using a guillotine and a cutter after a slip sheet is laminated on the overcoat layer.

In this aspect, since the adhesion between the overcoat layer and slip sheet can be reduced and the peeling property of the slip sheet is improved by controlling the crystallization degree, troubles of carrying the slip sheet into the laser exposure section or the development section upon peeling the slip sheet at the platesetter can be avoided, and the transferability in a platesetter of the lithographic printing plate can be improved. In the seventh aspect, the web-like raw continuous sheet of the produced photopolymerizable lithographic plate may be continuously processed in the step of processing sheet, or discontinuously after being taken up onto a take-up machine.

As described above, according to the method of producing a photopolymerizable lithographic plate of the present invention, a photopolymerizable lithographic plate having stable sensitivity and excellent qualities free of occurrence of failure due to poor plate wearing, failure due to defective development such as residual film or residual color, or bleaching or failure due to residual film caused by a flaw in the overcoat layer can be produced, and the moisture content of the overcoat layer can be easily and reliably controlled without establishing expensive air-conditioning equipment or even in high speed production line.

## BRIEF DESCRIPTION OF THE DRAWING

Fig. 1 illustrates an example of a production line to which the method of producing a photopolymerizable lithographic plate of the present invention is applied.

## DETAILED DESCRIPTION OF THE PREFERRED EMBODIMENTS

Hereinafter, preferred embodiments of the method of producing a photopolymerizable lithographic plate of the present invention are described referring to the attached figure. Obviously, the scope of the present invention is not limited to such description.

Fig. 1 illustrates an example of a production line 10 to which the method of producing a photopolymerizable lithographic plate of the present invention is applied.

As shown in Fig. 1, a rolled, long-sheet support 14 is set on a feeder 12. The support 14 continuously fed from the feeder 12 is surface-treated at a surface-treatment section 16. A back coat layer is formed on the back of the surface-treated support 14 at a back coat layer applying and drying section 18, and then at a base coat applying and drying section 20, a base coat layer is formed on the top of the support 14. Then, at a photosensitive layer applying and drying section 22, a photosensitive layer of a photopolymerizable composition is formed on the base coat layer, and then at an overcoat layer applying and drying section 24, an overcoat layer containing, as a main component, a water-soluble polymer containing a hydrogen bond forming group is formed and the crystallization degree of the water-soluble polymer of the formed overcoat layer is controlled to a pre-determined range. Subsequently, the moisture content of the overcoat layer is controlled to a pre-determined range at a humidity-controlled zone for overcoat layer 26. The moisture content of the overcoat layer is measured by an infrared radiation thermometer 31 online, and an air-conditioning unit 32 of the humidity-controlled zone for overcoat layer controls the temperature and humidity of the humidity-controlled zone for overcoat layer, so that the data of the moisture content is settled. Raw continuous sheet 14A of the lithographic printing plate is thus produced and taken up onto a take-up machine 28.

[Support]

For the support 14 used in the present invention, dimensionally stable aluminum or an alloy thereof (e.g. alloy with silicon, copper, manganese, magnesium, chromium, zinc, lead, bismuth or nickel) may be used. Generally, conventionally known materials listed in Aluminum Handbook 4th ed. (1990, published by Japan Light Metal Association) such as materials of JIS A 1050, JIS A1100, JIS A3103, JIS A3004, JIS A3005 or an alloy obtained by adding 0.1 wt% or more of magnesium to these materials for improving tensile strength may be used.

As an aluminum plate, those produced by a continuous casting method may be used in addition to aluminum plates produced by a usual semi-continuous die casting method (DC method). For the continuous casting method, a twin-roll method, a belt caster method and a block caster method may be used. The content of foreign element in the alloy is not more than 10% by weight. The thickness of the aluminum plate is preferably about 0.1 mm to 0.6 mm. In addition, a plastic film or paper to which aluminum or an aluminum alloy is laminated or deposited may also be used.

[Surface treatment of support]

When the support 14 is an aluminum plate, the surface thereof is usually subjected to various surface treatments depending on purposes. In a general treatment method, the surface of the aluminum plate is first cleaned by degreasing or electropolishing and desmut treatment. The plate is then subjected to mechanical surface roughening treatment and/or electrochemical surface roughening treatment to create small irregularities on the surface of the aluminum plate. At this stage, chemical etching treatment and desmut treatment may also be conducted. After that, anodizing treatment is conducted in order to increase the abrasion resistance of the surface of the aluminum plate, and the aluminum surface is then subjected to hydrophilizing treatment and/or sealing treatment according to need.

Between each treatment, draining by a nip roller and water washing using a spray are preferably conducted in order to prevent the treating solution of the prior treatment from being introduced to the next treatment. Overflow waste liquid of the electrolytic solution used for the electrochemical surface roughening treatment may be used as a solution for desmut treatment, and in that case, the water washing after the desmut treatment may be omitted.

(Degreasing and electropolishing treatment)

After removing rolling oil, natural oxide film and dirt on the aluminum plate, the aluminum plate is subjected to electropolishing treatment in an acidic aqueous solution or chemical etching treatment in an acidic or alkaline aqueous solution to conduct electrochemical surface roughening uniformly. The amount of the aluminum plate dissolved is preferably 1 to 30 g/m$^2$, more preferably 1.5 to 20 g/m$^2$.

(1) Electropolishing treatment

Examples of electropolishing treatment for each material are described in a paper by Fujio Mamiya, "Surface Control", No.21, pp 65-72, (1984).

Known aqueous solutions used for electropolishing can be used. An aqueous solution containing sulfuric acid or phosphoric acid as a main component is preferable, and an aqueous solution containing phosphoric acid as a main component is particularly preferable.

Conditions can be selected from a proportion of phosphoric acid of 20 to 90% by weight (preferably 40 to 80% by weight), a liquid temperature of 10 to 90°C (preferably 50 to 80°C), a current density of 1 to 100 A/dm$^2$ (preferably 5 to 80 A/dm$^2$) and an electrolysis time of 1 to 180 seconds. 1 to 50% by weight of sulfuric acid, chromic acid, hydrogen peroxide, citric acid, hydrofluoric acid or phthalic anhydride may be added to the aqueous phosphoric acid solution.

Referring to current, direct current, pulse direct current or alternate current may be used, and continuous direct current is preferable. As an electrolytic apparatus, known apparatuses used for electrolytic treatment such as flat bath or radial bath may be used. The current may be in either a parallel flow or a counter flow relative to the aluminum plate, and the flow rate is selected from the range of 0.01 to 10000 cm/minute.

The distance between the aluminum plate and the electrode is preferably from 0.3 to 10 cm, particularly preferably 0.8 to 2 cm. For the feeding system, a direct feeding system using a conductor roll may be used or an indirect feeding system without a conductor roll (liquid feeding system) may be used. For the material and the structure of the electrode to be used, known materials and structures used for electrolytic treatment can be used, and the material of the cathode is preferably carbon and the material of the anode is preferably ferrite, iridium oxide or platinum.

(2) Etching treatment in acidic or alkaline aqueous solution

Details of chemical etching treatment of an aluminum plate in an acidic or alkaline aqueous solution are described

in U.S. Patent No. 3,834,398, and these known methods may be used. For acid or alkali that can be used for the acidic or alkaline aqueous solution, those described in Japanese Patent Application Laid Open No. 57-16918 and the like may be used alone or in combination. It is preferable to conduct the treatment at a liquid temperature of 25 to 90°C for 1 to 120 seconds. The concentration of the acidic aqueous solution is preferably 0.5 to 25 % by weight, and the proportion of aluminum dissolved in the acidic aqueous solution is preferably 0.5 to 5 % by weight. The concentration of the alkaline aqueous solution is preferably 5 to 30% by weight, and the proportion of aluminum dissolved in the alkaline aqueous solution is preferably 1 to 30% by weight.

(Desmut treatment)

In the case of chemical etching using an aqueous solution containing a base, smut is generally formed on the surface of aluminum after the etching treatment, and therefore treatment (desmut treatment) is conducted using phosphoric acid, nitric acid, sulfuric acid, chromic acid or a mixed acid containing at least two of these.

The acidic aqueous solution to be used may be one in which 0 to 5 % by weight of aluminum is dissolved, and the treatment is conducted at a liquid temperature of room temperature to 70°C, and the time of treatment is preferably from 1 to 30 seconds. As the acidic aqueous solution, waste liquid of the electrolytic solution used for electrochemical surface roughening treatment may be used, but attention should be paid so as to avoid deposition of components in the desmut solution upon drying of the aluminum plate.

After the completion of the desmut treatment, draining by a nip roller and water washing using a spray are preferably conducted in order to prevent mixing of the treating solution to the next step, but the water washing may be omitted when the same kind of aqueous solution is used in the next step.

(Mechanical roughening treatment)

In order to obtain an excellent aluminum support, the surface of an aluminum plate is generally subjected to graining to create small irregularities. As such graining, mechanical surface roughening treatment such as ball graining, brush graining, wire graining and blast graining are generally known, and brush graining is excellent for a large-scale, continuous treatment.

In the brush graining treatment, one or a plurality of brushes are generally used, and examples thereof include a method in which a plurality of one certain kind of brushes are used as described in Japanese Examined Application Laid Open No. 50-40047 and a method of using brushes of different materials, diameters or cross-sections as described in Japanese Patent Application Laid Open No. 6-135175. Specifically, slurry of silica sand or aluminum hydroxide is sprayed on the surface of an aluminum plate and a nylon brushing roll having a brush diameter of 0.2 to 0.9 mm is rotated at 50 to 500 rpm to conduct mechanical surface roughening treatment. Regarding the pushing strength of the brush, the power consumption of rotational driving motor (substantial electric power exclusive of mechanical loss of the driving motor) is preferably 0.2 to 15 kw, further preferably 0.5 to 10 kw.

(Electrochemical surface roughening treatment)

(1) In electrochemical surface roughening treatment using alternate current, as an aqueous solution containing hydrochloric acid or nitric acid as a main component, those used for usual electrochemical surface roughening treatment using alternate current may be used. At least one hydrochloric acid compound containing chloride ions or nitric acid compound such as aluminum nitrate, sodium nitrate and ammonium nitrate is added to an aqueous 1 to 100 g/l hydrochloric acid or nitric acid solution in a proportion of 1 g/l to saturation to be used as the aqueous solution. Metal contained in an aluminum alloy such as iron, copper, manganese, titanium, magnesium or silica may be dissolved in the aqueous solution containing hydrochloric acid or nitric acid as a main component. It is preferable to use a solution obtained by adding aluminum chloride or aluminum nitrate to an aqueous solution containing 0.5 to 2% by weight of hydrochloric acid or nitric acid so that the proportion of aluminum ions is 3 to 50 g/l. The temperature is preferably 10 to 60°C, more preferably 25 to 50°C. As an apparatus for electrochemical roughening using direct current, known apparatuses using direct current may be used, and an apparatus in which at least one pair of anode and cathode is alternately positioned as described in Japanese Patent Application Laid Open No. 1-141094 is preferably used. Examples of known apparatus are described in Japanese Patent Application Laid Open No. 1-141094, Japanese Patent Application No. 6-205657, Japanese Patent Application Laid Open No. 61-19115 and Japanese Examined Application Laid Open No. 57-44760. For direct current used for electrochemical roughening, direct current having a ripple rate of not more than 20% may be used. The current density is preferably 10 to 200 $A/dm^2$, and when the aluminum plate is on the anode, the quantity of electricity is preferably 10 to 1000 $C/dm^3$.

The anode may be selected for use from known oxygen generating electrodes such as ferrite, iridium oxide, platinum and those obtained by cladding or plating platinum on valve metal such as titanium, niobium or zirconium. The cathode may be selected for use from carbon, platinum, titanium, niobium, zirconium, stainless steel and cathodes for fuel cells.

(2) In electrochemical surface roughening treatment using alternate current, as an aqueous solution containing hydrochloric acid or nitric acid as a main component, those used for usual electrochemical surface roughening treatment using alternate current may be used. At least one nitric acid compound containing nitrate ions such as aluminum nitrate, sodium nitrate and ammonium nitrate and hydrochloric acid compound containing chloride ions such as aluminum chloride, sodium chloride and ammonium chloride is added to an aqueous 1 to 100 g/l hydrochloric acid or nitric acid solution in a proportion of 1 g/l to saturation to be used as the aqueous solution. Metal contained in an aluminum alloy such as iron, copper, manganese, nickel, titanium, magnesium or silica may be dissolved in the aqueous solution containing hydrochloric acid or nitric acid as a main component. It is preferable to use a solution obtained by adding aluminum chloride or aluminum nitrate to an aqueous solution containing 0.5 to 2% by weight of hydrochloric acid or nitric acid so that the proportion of aluminum ions is 3 to 50 g/l. The temperature is preferably 10 to 60°C, more preferably 25 to 50°C.

(3) The waveform of the alternating current from a power source used for electrochemical roughening treatment may be sinusoidal, square, trapezoidal or triangular, preferably square or trapezoidal, particularly preferably trapezoidal. The time (TP) for the current to reach a peak from zero is preferably from 1 to 3 msec. When the time is less than 1 msec, irregularity called chatter mark, which is formed in the direction perpendicular to the traveling direction of the aluminum plate, tends to be easily formed. When the TP is more than 3 msec, influence of trace components which naturally increase by electrolysis treatment in the electrolytic solution used for the electrochemical roughening, such as ammonium ion, tends to grow, making it difficult to conduct uniform graining.

(4) Trapezoidal alternate current having a duty ratio of 1:2 to 2:1 may be used, and as described in Japanese Patent Application Laid Open No. 5-19300, one having a duty ratio of 1:1 is preferable in the case of indirect feeding system in which no conductor roll is used for aluminum. Trapezoidal alternate current having a frequency of 0.1 to 120 Hz may be used, and 50 to 70 Hz is preferable in view of facilities. When the frequency is less than 50 Hz, the carbon electrode which is the main electrode tends to be dissolved easily. When it is more than 70 Hz, influence of inductance components on the power supply circuit tends to increase, causing high cost of power supply. In this regard, when using an aluminum alloy containing more than 0.1 wt% of Cu, alternate current having a frequency of 0.1 to 10 Hz is preferably used. The current density is preferably 10 to 200 A/$dm^2$ at the peak of the current wave.

(5) As an electrolytic bath used in the electrochemical surface roughening treatment, known electrolytic bathes used for surface treatment such as vertical, flat or radial bath may be used, and a radial electrolytic bath described in Japanese Patent Application Laid Open No. 5-195300 is particularly preferable. The electrolytic solution which passes through the electrolytic bath may be in either a parallel flow or counter flow to the traveling direction of the aluminum web.

(6) One or more AC power supplies may be connected to the electrolytic bath. It is preferable that while controlling the current ratio between the anode and the cathode of alternate current applied to the aluminum plate opposed to the main electrode, an auxiliary anode for preventing dissolution of the main carbon electrode is installed to shunt the alternate current. By shunting part of the current as direct current to the auxiliary anode provided in a bath different from the bath in which the two main electrodes are provided via a rectifying device or a switching device, the ratio of the current value for the anodizing reaction to the current value for the cathodic reaction, which current is exerted on the aluminum plate opposed to the main electrode, can be controlled. The ratio of the quantities of electricity (quantity of electricity at cathode/quantity of electricity at anode) for the anodizing reaction and the cathodic reaction on the aluminum plate opposed to the main electrode is preferably 0.3 to 0.95.

(7) Japanese Patent Application Laid Open No. 6-135175 describes that the waveform of alternate current used in the electrochemical roughening step is sinusoidal, trapezoidal or square. Japanese Patent Application Laid Open No. 5-195300 describes use of a radial electrolytic bath in the electrochemical roughening treatment and installation of an auxiliary anode in the same bath in which the main electrode is placed. In addition, Japanese Examined Application Laid Open No. 6-37716 describes shunting of part of current as direct current to an auxiliary anode provided separately from the two main electrodes.

(8) In an aqueous solution containing nitric acid or hydrochloric acid as a main component, the aluminum plate is subjected to electrochemical surface roughening treatment using alternate current or direct current with a quantity of electricity of 10 to 1000 C/$dm^2$. The treatment is conducted in an acidic aqueous solution, and the time for the current to reach a peak from zero is from 1 to 3 msec and trapezoidal alternate current having a frequency of 50 to 70 Hz is used.

(Chemical etching treatment (in acidic or alkaline solution))

Chemical etching treatment is conducted for smoothing small grained irregularities created by mechanical surface roughening treatment or electrochemical surface roughening treatment, or for removing smut. Details of the etching method are described in U.S. Patent No. 3,834,398, and these known methods may be used. For acid or alkali that can be used for the acidic or alkaline aqueous solution, those described in Japanese Patent Application Laid Open No. 57-16918 and the like may be used alone or in combination. It is preferable to conduct the treatment at a liquid temperature of 25 to 90°C for 1 to 120 seconds. The concentration of the acidic aqueous solution is preferably 0.5 to 25% by weight, and the proportion of aluminum dissolved in the acidic aqueous solution is preferably 0.5 to 5% by weight. The concentration of the alkaline aqueous solution is preferably 5 to 30% by weight, and the proportion of aluminum dissolved in the alkaline aqueous solution is preferably 1 to 30% by weight.

The etching treatment is conducted so that the amount of the aluminum plate dissolved in the acidic or alkaline aqueous solution is not less than 1 $g/m^2$ to not more than 30 $g/m^2$ (E treatment: etching after mechanical surface roughening treatment) or the amount of aluminum plate dissolved therein is not less than 0.1 $g/m^2$ to not more than 3 $g/m^2$ (F treatment: electrochemical roughening treatment).

In the case of chemical etching using an aqueous solution containing a base, smut is generally formed on the surface of aluminum. In that case, etching treatment (required desmut treatment) is conducted using phosphoric acid, nitric acid, sulfuric acid, chromic acid or a mixed acid containing at least two of these (as in the desmut treatment described above).

(Anodizing treatment)

In order to increase the water retention property and the abrasion resistance of the surface of the aluminum plate, anodizing treatment is conducted. Any electrolyte may be used for the anodizing treatment of the aluminum plate as long as it can form a porous oxide film. Generally, sulfuric acid, phosphoric acid, oxalic acid, chromic acid or a mixed solution thereof is used. The concentration of these electrolytes is determined depending on the kind of the electrolyte. The conditions of the anodizing treatment cannot be simply determined as they are different depending on the kind of electrolyte, but generally a concentration of the electrolyte of 1 to 80 wt%, a liquid temperature of 5 to 70°C, a current density of 1 to 60 $A/dm^2$, a voltage of 1 to 100 V, and an electrolysis time of 5 seconds to 300 seconds are appropriate.

Sulfuric acid methods are generally conducted using a direct current, but alternate current may also be used. The amount of anodized film is preferably in the range of 0.5 to 10 $g/m^2$. Sulfuric acid is used at a concentration of 5 to 30%, and the electrolytic treatment is conducted at a temperature range of 20 to 60°C for 5 to 250 seconds. It is preferable that the electrolytic solution contains aluminum ions. The current density in this case is preferably 1 to 50 $A/dm^2$. In the case of a phosphoric acid method, treatment is conducted at a concentration of 5 to 50%, a temperature of 30 to 60°C and at a current density of 1 to 15 $A/dm^2$ for 10 to 300 seconds. The amount of anodized film is preferably not less than 1.0 $g/m^2$, more preferably 2.0 to 6.0 $g/m^2$.

(Hydrophilizing treatment)

After conducting the anodizing treatment, the surface of the aluminum is subjected to hydrophilizing treatment according to need. Examples of the hydrophilizing treatment to be employed in the present invention include a method using alkali metal silicate (e.g. an aqueous sodium silicate solution) as disclosed in U.S. Patent Nos. 2,714,066, 3,181,461, 3,280,734 and 3,902,734. In these methods, the support is immersed or subjected to electrolysis in the aqueous sodium silicate solution. It is also possible to employ a method involving treatment with potassium fluorozirconate as disclosed in Japanese Examined Application Laid Open No. 36-22063, or a method involving treatment with polyvinylphosphonic acid as disclosed in U.S. Patent Nos. 3,276,868, 4,153,461 and 4,689,272.

(Other treatment (water-washing, sealing))

After the completion of each treatment, draining by a nip roller and water washing using a spray are conducted in order to prevent mixing of the treating solution to the next step. It is also preferable to conduct sealing treatment after the anodizing treatment. Such sealing treatment is conducted by immersion into hot water and hot aqueous solution containing an inorganic salt or an organic salt, and in a steam drier.

[Formation of back coat layer]

At a back layer applying and drying section 18, a coating layer (hereinafter referred to as back coat layer) composed of an organic polymer compound is formed on the back of the support 14 according to need for preventing

scuffing of the photosensitive composition layer when superposed. As a main component of the back coat layer, at least one resin having a glass transition temperature of not less than 20°C selected from the group consisting of saturated copolymerized polyester resin, phenoxy resin, polyvinyl acetal resin and vinylidene chloride copolymerized resin may be used. The saturated copolymerized polyester resin comprises dicarboxylic acid units and diol units. Examples of the dicarboxylic acid unit of the polyester used in the present invention include aromatic dicarboxylic acids such as phthalic acid, terephthalic acid, isophthalic acid, tetrabromophthalic acid and tetrachlorophthalic acid and saturated aliphatic dicarboxylic acids such as adipic acid, azelaic acid, succinic acid, oxalic acid, suberic acid, sebacic acid, malonic acid and 1,4-cyclohexanedicarboxylic acid. The back coat layer may additionally includes a dye or a pigment for coloring, a silane coupling agent, diazo resin composed of a diazonium salt, organic phosphonic acid, organic phosphoric acid and a cationic polymer for improving adhesion to the support, and wax, higher fatty acid, higher fatty acid amide, a silicone compound comprising dimethylpolysiloxane, modified dimethylsiloxane and polyethylene powder which are usually used as a lubricant. Basically, the back coat layer may have a thickness that can prevent the photosensitive composition layer from scuffing even in the absence of a slip sheet, and a thickness of 0.01 to 8 μm is preferable. Various methods may be used to form the back coat layer on the back of the support 14, and examples thereof include a method in which a solution or emulsified dispersion is prepared using a suitable solvent and the solution or dispersion is applied and dried; a method in which a film formed in advance is laminated on the support 14 using an adhesive or heat; and a method in which a molten film is formed by a melt extruder and then the film is laminated on the support 14. Most preferred for achieving the aforementioned coating amount is the method of forming a solution and applying and drying the same. As the solvent in these methods, organic solvents described in Japanese Patent Application Laid Open No. 62-251739 may be used alone or in a mixture. For the applying method and condition, many of the methods and conditions of applying the photosensitive composition layer described below may be used. That is, a method using a coating rod, a method using an extrusion coater and a method using a slide bead coater may be used. As the conditions of application and the properties of the solution, those described above may be used.

[Formation of base coat layer]

At the base coat applying and drying section 20, a base coat layer coating solution is applied to the surface of the support 14 where necessary and the solution is dried to form a base coat layer. As the methods and conditions of application in the base coat applying and drying section 20, many of those used for applying a photosensitive composition layer described below may be used. That is, a method using a coating rod, a method using an extrusion coater and a method using a slide bead coater may be used. As the conditions of application and the properties of the solution, those described in the case of applying a photosensitive composition layer may be used.

[Formation of photosensitive layer]

At the photosensitive layer applying and drying section 22, coating of photopolymerizable photosensitive composition is applied to the base coat layer and the coating is dried to form a photosensitive layer.

Organic solvents described in Japanese Patent Application Laid Open Nos. 62-251739 and 6-242597 may be used as a solvent for dissolving the photopolymerizable photosensitive composition. The photopolymerizable photosensitive composition is dissolved and dispersed at a solid concentration of 2 to 50% by weight and applied to the support 14 and dried. The amount of photopolymerizable photosensitive composition layer (photosensitive layer) to be applied on the support 14 is different depending on the purpose of use, and is generally preferably 0.3 to 4.0 g/m$^2$ based on the weight after drying. The smaller the amount to be applied, the smaller the amount of exposure for obtaining an image, but the more the film strength is reduced. On the other hand, the larger the amount to be applied, the stronger the photosensitive film although the amount of exposure required is increased. For example, when used as a printing plate, a printing plate capable of printing a great number of copies (high plate wearing) can be obtained. The photosensitive composition may contain a surfactant, particularly preferably a fluorine surfactant, to improve the property of the coated surface.

The photopolymerizable photosensitive composition constituting the photosensitive layer of the photosensitive lithographic printing plate used in the present invention contains, as essential components, an ethylenically unsaturated compound which can be polymerized by addition polymerization, a photopolymerization initiator and a polymer binder, and where necessary, various compounds such as a colorant, a plasticizer and a thermal polymerization inhibitor may be used together.

The ethylenically unsaturated compound has an ethylenically unsaturated bond and is polymerized by addition polymerization due to the action of a photopolymerization initiator to be cross-linked and cured when the photopolymerizable photosensitive composition is irradiated with active rays.

The addition-polymerizable compound containing an ethylenic double bond can be optionally selected from compounds having at least one, preferably at least two terminal ethylenically unsaturated bonds.

These compounds have a variety of chemical forms, including monomers and prepolymers (e.g. dimers, trimers, and oligomers), as well as mixtures and copolymers thereof.

Examples of such monomers and their copolymers include esters of unsaturated carboxylic acid (e.g. acrylic acid, methacrylic acid, itaconic acid, crotonic acid, isocrotonic acid, maleic acid) and an aliphatic polyol compound, and amides of unsaturated carboxylic acid and an aliphatic polyamine compound.

Examples of the ester of an aliphatic polyol compound and unsaturated carboxylic acid as a monomer include acrylic acid esters such as ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol pentaacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate and polyester acrylate oligomers.

Methacrylic acid esters include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis[p-(3-methacryloxy-2-hydroxypropoxy)phenyl]dimethylmethane and bis[p-(methacryloxyethoxy)phenyl]dimethylmethane.

Itaconic acid esters include ethylene glycol diitaconate, propylene glycol diitaconate, 1,3-butanediol diitaconate, 1,4-butanediol diitaconate, tetramethylene glycol diitaconate, pentaerythritol diitaconate and sorbitol tetraitaconate.

Crotonic acid esters include ethylene glycol dicrotonate, tetramethylene glycol dicrotonate, pentaerythritol dicrotonate and sorbitol tetradicrotonate.

Isocrotonic acid esters include ethylene glycol diisocrotonate, pentaerythritol diisocrotonate and sorbitol tetraisocrotonate.

Maleic acid esters include ethylene glycol dimaleate, triethylene glycol dimaleate, pentaerythritol dimaleate and sorbitol tetramaleate.

Examples thereof also include a mixture of the above-mentioned ester monomers.

Specific examples of the amide of an aliphatic polyamine compound and unsaturated carboxylic acid as a monomer include methylene-bis-acrylamide, methylene-bis-methacrylamide, 1,6-hexamethylene-bis-acrylamide, 1,6-hexamethylene-bis-methacrylamide, diethylenetriamine-tris-acrylamide, xylylene-bis-acrylamide and xylylene-bis-methacrylamide.

Other examples include vinyl urethane compounds having two or more polymerizable vinyl groups per molecule obtained by adding a hydroxyl group-containing vinyl monomer of the following formula (A) to a polyisocyanate compound having at least two isocyanate groups per molecule, which is described in Japanese Examined Application Laid Open No. 48-41708.

$$CH_2=C(R5)COOCH_2CH(R6)OH \qquad (A)$$

(in which R5 and R6 represent H or $CH_3$)

Furthermore, polyfunctional acrylates and methacrylates such as urethane acrylates described in Japanese Patent Application Laid Open No. 51-37193, Japanese Examined Application Laid Open No. 2-32293, polyester acrylates described in Japanese Patent Application Laid Open No. 48-64183, Japanese Examined Application Laid Open Nos. 49-43191 and 52-30490, and epoxy acrylates obtained by reacting an epoxy resin and (meth)acrylic acid may be used. In addition, photo-curing monomers and oligomers proposed in Journal of the Adhesion Society of Japan, vol.20, No.7, pp. 300 to 308 (1984) may also be used.

The amount to be used of the ethylenically unsaturated compound is 5 to 80% by weight, preferably 30 to 70% by weight based on the total components of the photosensitive layer.

As the photopolymerization initiator to be contained in the photosensitive layer of the photosensitive lithographic printing plate according to the present invention, various known photopolymerization initiators described in patent publications and references, or combination system (photo-initiation system) of at least two of those photopolymerization initiators may be selected and used depending on the wavelength of the light source to be used. Specific examples thereof are listed below, but the initiators are not limited to these.

Various photo-initiation systems are also proposed in the case of using light sources such as visible light of 400 nm or more, Ar lasers, second harmonic wave of semiconductor lasers, SHG-YAG lasers and solid lasers and semiconductor lasers which emit infrared rays of a wavelength of 760 nm to 1200 nm. Examples of the system include a system of a certain kind of photoreducing dye such as Rose Bengale, eosin and erythrosine as described in U.S. Patent No. 2,850,445, a combination system of a dye and an initiator, e.g. a composite initiation system of dye and

amine (Japanese Examined Application Laid Open No. 44-20189), a combination system of hexaarylbiimidazole, radical generator and dye (Japanese Examined Application Laid Open No. 45-37377), a system of hexaarylbiimidazole and p-dialkylaminobenzylidene ketone (Japanese Examined Application Laid Open No. 47-2528 and Japanese Patent Application Laid Open No. 54-155292), a system of cyclic cis- α-dicarbonyl compound and dye (Japanese Patent Application Laid Open No. 48-84183), a system of cyclic triazine and merocyanine dye (Japanese Patent Application Laid Open No. 54-151024), a system of 3-ketocoumarin and activator (Japanese Patent Application Laid Open Nos. 52-112681 and 58-15503), a system of biimidazole, styrene derivative and thiol (Japanese Patent Application Laid Open No. 59-140203), a system of organic peroxide and dye (Japanese Patent Application Laid Open Nos. 59-1504, 59-140203, 59-189340, 62-174203, Japanese Examined Application Laid Open No. 62-1641 and U.S. Patent No. 4,766,055), a system of dye and active halogen compound (Japanese Patent Application Laid Open Nos. 63-258903 and 2-63054), a system of dye and borate compound (Japanese Patent Application Laid Open Nos. 62-143044, 62-150242, 64-13140, 64-13141, 64-13142, 64-13143, 64-13144, 64-17048, 1-229003, 1-298348 and 1-138204), a system of dye having a rhodanine ring and radical generator (Japanese Patent Application Laid Open Nos. 2-179643 and 2-244050), a system of titanocene and 3-ketocoumarin dye (Japanese Patent Application Laid Open No. 63-221110), a combination system of titanocene, xanthene dye and addition-polymerizable ethylenically unsaturated compound containing an amino group or a urethane group (Japanese Patent Application Laid Open Nos. 4-221958 and 4-219756), a system of titanocene and specific merocyanine dye (Japanese Patent Application Laid Open No. 6-295061) and a system of titanocene and dye having a benzopyran ring (Japanese Patent Application Laid Open No. 8-334897).

In addition, lasers (violet lasers) with a wavelength of 400 to 410 nm have been recently developed and a photo-initiation system corresponding to these which has high sensitivity to a wavelength of 450 nm or less has been developed, and so such photo-initiation system may also be used.

Examples thereof include a cationic dye/borate system (Japanese Patent Application Laid Open No. 11-84647), a merocyanine dye/titanocene system (Japanese Patent Application Laid Open No. 2000-147763) and a carbazole dye/titanocene system (Japanese Patent Application No. 11-221480).

In the present invention, systems using a titanocene compound are particularly preferred because they have an excellent sensitivity.

Various titanocene compounds can be used and for example, they may be appropriately selected from the compounds described in Japanese Patent Application Laid Open Nos. 59-152396 and 61-151197. Specific examples thereof include dicyclopentadienyl-Ti-dichloride, dicyclopentadienyl-Ti-bis-phenyl, dicyclopentadienyl-Ti-bis-2,3,4,5,6-pentafluorophen-1-yl, dicyclopentadienyl-Ti-bis-2,3,5,6-tetrafluorophen- l -yl, dicyclopentadienyl-Ti-bis-2,4,6-trifluorophen-1-yl, dicyclopentadienyl-Ti-bis-2,6-difluorophen-1-yl, dicyclopentadienyl-Ti-bis-2,4-difluorophen-1-yl, di-methylcyclopentadienyl-Ti-bis-2,3,4,5,6-tetrafluorophen-1-yl, di-methylcyclopentadienyl-Ti-bis-2,6-difluorophen-1-yl and dicyclopentadienyl-Ti-bis-2,6-difluoro-3-(pyr-1-yl)phen-1-yl.

In addition, it is known that the photo-initiation ability of the photopolymerization initiator can be increased by adding thereto a hydrogen-donating compound such as thiol compounds such as 2-mercaptobenzothiazole, 2-mercaptobenzimidazole and 2-mercaptobenzoxazole, N-phenylglycine and amine compounds such as N,N-dialkylamino aromatic alkyl ester, according to need.

The photopolymerization initiator (system) is generally used in an amount of 0.05 to 100 parts by weight, preferably from 0.1 to 70 parts by weight, more preferably from 0.2 to 50 parts by weight, based on 100 parts by weight of the ethylenically unsaturated bond-containing compound.

As the polymer binder used for the photosensitive layer of the photosensitive lithographic printing plate according to the present invention, organic high molecular weight polymers which are soluble or swellable in alkaline water are used, because they should not only serve as a film-forming agent of the compound but also be dissolved in alkaline developer.

When the organic high molecular weight polymer used is, for example, a water-soluble organic high molecular weight polymer, water development can be performed. Examples of such organic high molecular weight polymer include addition polymers having a carboxylic acid group on the side chain described, for example, in Japanese Patent Application Laid Open No. 59-44615, Japanese Examined Application Laid Open Nos. 54-34327, 58-12577, 54-25957, Japanese Patent Application Laid Open Nos. 54-92723, 59-53836 and 59-71048, such as methacrylic acid copolymers, acrylic acid copolymers, itaconic acid copolymers, crotonic acid copolymers, maleic acid copolymers and partially esterified maleic acid copolymers.

Likewise, another example is acidic cellulose derivatives having a carboxylic acid group on the side chain. In addition to these, those obtained by adding a cyclic acid anhydride to an addition polymer having a hydroxyl group are useful. Of these, particularly preferred are [benzyl(meth)acrylate/(meth)acrylic acid/ other addition-polymerizable vinyl monomer, if required] copolymers and [allyl(meth)acrylate/(meth)acrylic acid/ other addition-polymerizable vinyl monomer, if required] copolymers. In addition, polyvinylpyrrolidone and polyethylene oxide are useful as the water-soluble organic high molecular weight polymer. Further, for increasing the strength of cured film, alcohol-soluble polyamide and polyether of 2,2-bis-(4-hydroxyphenyl)-propane and epichlorohydrin are useful.

In addition, polyurethane resins described in Japanese Examined Application Laid Open Nos. 7-120040, 7-120041, 7-120042, 8-12424, Japanese Patent Application Laid Open Nos. 63-287944, 63-287947, 1-271741 and 11-352691 are also useful for the present invention.

The strength of the cured film can be increased by introducing a radical reactive group into the side chain of the organic high molecular weight polymer. Examples of the functional group which can induce an addition polymerization reaction include an ethylenically unsaturated bond group, an amino group and an epoxy group; examples of the functional group which can be converted to a radical upon light irradiation include a mercapto group, a thiol group, a halogen atom, a triazine structure and an onium salt structure; and examples of the polar group include a carboxyl group and an imide group. As the above-mentioned functional group which can induce an addition polymerization reaction, ethylenically unsaturated bond groups such as acryl group, methacryl group, allyl group and styryl group are preferred, and a functional group selected from an amino group, a hydroxy group, a phosphonic acid group, a phosphoric acid group, a carbamoyl group, an isocyanate group, a ureido group, a ureylene group, a sulfonic acid group and an ammonio group is also useful.

To maintain the developing property of the composition, the polymer binder used in the present invention should have an appropriate molecular weight and an appropriate acid value, and high molecular weight polymers having a weight average molecular weight of 5,000 to 300,000 and an acid value of 20 to 200 are effectively used.

The organic high molecular weight polymer can be mixed in any amount based on the total composition. However, an amount of more than 90% by weight cannot afford preferable results of, for example, the strength of images to be formed. The amount is preferably 10 to 90%, more preferably 30 to 80%. The proportion of the photopolymerizable ethylenically unsaturated compound and the organic high molecular weight polymer is preferably in the range of 1/9 to 9/1 based on weight. A more preferable range thereof is 2/8 to 8/2, and a further preferable range thereof is 3/7 to 7/3.

In the present invention, in order to prevent unnecessary thermal polymerization of the polymerizable ethylenically unsaturated compound during the production or storage of the photosensitive composition, a small amount of a thermal polymerization inhibitor is preferably added in addition to the above-described basic components. Suitable examples of the thermal polymerization inhibitor include hydroquinone, p-methoxyphenol, di-t-butyl-p-cresol, pyrogallol, t-butylcatechol, benzoquinone, 4,4'-thiobis(3-methyl-6-tert-butylphenol), 2,2'-methylenebis(4-methyl-6-tert-butylphenol), N-nitrosophenylhydroxyamine cerous salt and N-nitrosophenylhydroxylamine aluminum salt. The amount to be added of the thermal polymerization inhibitor is preferably about 0.01 % to about 5% based on the total weight of the composition. Where necessary, in order to prevent polymerization inhibition caused by oxygen, a higher fatty acid derivative or the like, such as behenic acid and behenic acid amide, may be added and localized on the surface of the photosensitive layer in the drying process after coating. The amount to be added of the higher fatty acid derivative is preferably about 0.5% to about 10% based on the total composition.

A coloring agent may be further added for the coloring of the photosensitive layer. Examples of the coloring agent include pigments such as phthalocyanine pigments (C.I. Pigment Blue 15:3, 15:4, 15:6, etc.), azo pigments, carbon black and titanium oxide, and dyes such as Ethyl Violet, Crystal Violet, azo dye, anthraquinone dye and cyanine dye. The amount to be added of the dye and the pigment is preferably about 0.5% to about 20% based on the total composition.

In addition, in order to improve physical properties of the cured film, additives such as inorganic filler and plasticizers such as dioctyl phthalate, dimethyl phthalate and tricresyl phosphate may be added. The amount to be added of such additive is preferably not more than 10% based on the total composition.

Upon coating the photosensitive composition on the support 14, the composition is used after dissolving in various types of organic solvents. Examples of the solvent used include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, 香 γ-butyrolactone, methyl lactate and ethyl lactate. These solvents may be used alone or in a mixture. The concentration of solids in the coating solution is preferably 1 to 50% by weight.

A surfactant may be added to the photopolymerizable composition of the photosensitive layer of the photosensitive lithographic printing plate according to the present invention in order to improve the property of the coated surface. An appropriate coating amount is in the range of about 0.1 g/m$^2$ to about 10 g/m$^2$ based on weight after drying. The coating amount is more preferably 0.3 to 5 g/m$^2$, further preferably 0.5 to 3 g/m$^2$.

(Coating method)

As a method of coating the photosensitive composition, a method using a coating rod described in Japanese

Examined Application Laid Open No. 58-4589 and Japanese Patent Application Laid Open No. 59-123568, a method using an extrusion coater described in Japanese Patent Application Laid Open No. 4-244265, and a method using a slide bead coater described in Japanese Examined Application Laid Open No. 1-57629 and Japanese Patent Application Laid Open No. 10-128212 may be used, but the method is not limited to these. In the following, some of the methods are described in detail.

(1) Rod coating method

The method using a coating rod comprises allowing moving support 14 to contact with a coating rod to obtain a pre-determined coating amount. The method using a coating rod includes a technique in which one coating rod has both functions of transferring the coating solution to apply it to the support 14 and adjusting the amount of the coating solution, and a technique in which the coating solution previously excessively applied to the support 14 is wiped by a coating rod to adjust the amount of the coating solution. The former is a method in which the coating solution is supplied so as to form a liquid pool immediately before the contact section of the coating rod and the support 14, and the coating amount is adjusted using the coating rod to obtain a desired coating amount.

In these methods using a coating rod, the coating rod may be in a stationary state or rotated in the direction the same as or opposite from that of the support 14 at any peripheral speed. In that case, the coating rod may be rotated compulsorily according to a method such as using an external driving device, or rotated following the support 14 in motion upon contact therewith.

The wrapping angle of the support 14 with respect to the coating rod may be set to the range of preferably 1° to 30°, more preferably 2° to 20°.

Regarding the properties of the coating solution, the viscosity is not more than 100 mPa·s (cp), more preferably not more than 50 mPa·s (cp), and the surface tension is preferably in the range of 20 to 70 mN/m (dyne/cm).

In this method, the coating amount is controlled by means of the size of the groove on the surface of the coating rod, and in the case of wire rod obtained by winding wire around a rod, the coating amount is controlled by the size of the wire. While the range to which the coating amount is controlled is not particularly limited, a range of 3 to 100 cc/$m^2$ is usually employed. The diameter of the coating rod is not particularly limited, but is 6 to 25 mm, preferably 6 to 15 mm. As a material of the rod, metal is preferable in view of the corrosion resistance and the strength, and stainless steel is particularly preferable.

As a coating rod used in the present invention, for example, a wire rod around which wire is thickly wound in the circumferential direction of the rod surface thereby forming grooves between wires, and a grooved rod having grooves engraved for the full length or at necessary portions of the rod surface in the circumferential direction are used.

When a wire rod is used, an appropriate wire diameter is 0.07 to 1.0 mm, preferably 0.07 to 0.6 mm. Metal is used as a material of wire, and in view of the corrosion resistance, abrasion resistance and strength, stainless steel is most preferable. Plating may be conducted on the surface of the wire rod for further improving the abrasion resistance, and hard chrome plating is particularly preferable.

When a grooved rod is used in the present invention, the pitch of the groove is 0.05 to 1.0 mm, preferably 0.1 to 0.6 mm, and the cross section is suitably substantially sinusoidal or trapezoidal. However, the cross-sectional shape is not limited to these and those with a different cross-sectional shape can also be used. Plating may be conducted on the surface of the grooved rod as well for further improving the abrasion resistance, and hard chrome plating is particularly preferable.

In view of the high speed rotation of the rod, a material having a low friction resistance with respect to the rod (wire in the case of a wire rod) must be selected as a material of a rod supporting member. Examples of the material of the rod supporting member and the barrier member include fluorine resins, polyacetal resins and polyethylene resins. Of these, polytetrafluoroethylene known as Teflon® (DuPont) and polyacetal resin known as Derlin® (DuPont) are particularly preferable from the viewpoint of the friction coefficient and the strength. In addition, those obtained by adding a filler such as glass fiber, graphite and molybdenum disulfide to these plastic materials can also be used. Further, after producing the rod supporting member using a metal material, the above-mentioned plastic materials may be coated on or attached to the surface to decrease the friction coefficient with respect to the bar. Alternatively, various kinds of metal materials impregnated with the above-mentioned plastic materials, e.g. aluminum impregnated with polytetrafluoroethylene, can also be used for the rod supporting member.

(2) Extrusion coating method

As another method, a method of coating comprising discharging a coating solution from an extrusion injector, winding it on a backup roller to form coating bead in the space between the injector and the moving support 14, and depressurizing the rear portion of the coating bead or pressurizing the front portion thereof can be used. In this method, about 10 to 500 cc/$m^2$ of the coating solution may be coated, although it depends on the clearance between the support

14 and the tip of the injector. For the properties of the coating solution, the viscosity is preferably in the range of 0.7 to 100 mPa·s (cp), and the surface tension is preferably in the range of 20 to 50 mN/m (dyne/cm). The clearance between the support 14 and the injector is generally 0.1 to 0.5 mm.

(3) Slide coating method

As yet another method, a method of coating comprising forming coating bead at a space where a liquid film of the coating solution dripping down the slide face meets the running support 14 at the edge of the slide face, thereby coating the coating solution on the support 14 through this bead can be used. Where necessary, the rear portion of the bead may be depressurized or the front portion thereof may be pressurized to coat. In this method, about 10 to 100 cc/$m^2$ of the coating solution may be applied. For the properties of the coating solution, the viscosity is preferably in the range of 1 to 200 mPa·s (cp), and the surface tension is preferably in the range of 20 to 60 mN/m (dyne/cm). The clearance between the support 14 and the injector is generally 0.1 to 0.6 mm.

(Drying method)

Next, drying methods are described. Examples of the drying method include a method in which a pass roll is placed in a drier and the support 14 is wrapped on the pass roll and transferred to conduct drying with spraying hot air thereto as described in Japanese Patent Application Laid Open No. 6-63487, a method in which air is supplied from the top face and the bottom face of the support 14 through a nozzle to dry the support 14 while it is lifted, a method of drying by radiant heat from hot plates placed above and below the strip as described in Japanese Patent Application Laid Open No. 60-149871, and a method of drying by heat conduction upon contact of the support 14 and a roll which is heated by passing a heat medium inside the roll as described in Japanese Patent Application Laid Open No. 60-21334.

In all methods, to uniformly dry the strip-shaped coating solution coated on the support 14, heating is controlled by changing the flow rate, the temperature or the manner of supply of hot air or heat medium depending on the kind and the coating amount of the support 14 and the photosensitive composition, the kind of solvent and the running speed. In addition, two or more of drying methods may be used in combination.

(1) Hot air drying method

In the hot air drying method, examples of the method of supplying hot air include a method in which hot air is supplied in the same direction as or the opposite direction from the traveling direction of the support 14, a method of spraying hot air from a plurality of slit nozzles provided perpendicularly to the traveling direction of the support 14 on the upper side of the support 14, and a method of supplying low-speed hot air through punching metal from the upper side of the support 14.

One or a plurality of these methods are conducted in combination depending on the kind and the coating amount of the support 14 and the photosensitive composition, the kind of solvent and the running speed. The method of supplying hot air may be changed depending on the positions of the drier at the initial, middle or later stage of drying.

In the method of supplying hot air along the traveling direction of the support 14, the speed of the hot air along the support 14 is preferably in the range of 0.3 to 8 m/s. In the method using slit nozzles, the speed of the hot air sprayed from the nozzles is 3 to 15 m/s, and the distance between the nozzle and the support is in the range of 5 to 200 mm. Further, in the method using punching metal, the speed of the hot air on the support 14 is not more than 2 m/s.

In all methods, a temperature of the hot air of 40°C to 170°C and a dew point of hot air of -5 to 25°C are preferably selected, and these can be accordingly selected depending on the kind and the coating amount of the support 14 and the photosensitive composition, the kind of solvent and the running speed. The temperature, the dew point and the speed of the hot air may be changed depending on the positions of the drier at the initial, middle or later stage of the drying.

(2) Heated roll method

In the method of drying by heat conduction upon contact of the support 14 and a roll which is heated by passing a heat medium inside the roll, the temperature of the roll through which a heat medium is passed and the time of contact of the support 14 and the roll can be accordingly selected so that a desired dried state is achieved, depending on the kind and the coating amount of the support 14 and the photosensitive composition, the kind of solvent and the running speed. As the heat medium supplied to the roll, oil, molten metal or super heated vapor is used.

[Formation of overcoat layer]

At the overcoat layer applying and drying section 24, overcoat layer coating is applied to the photosensitive layer by a coater. As the coater and the drier, those used for forming the base coat layer and the photosensitive layer may be used, and the drier is preferably of a hot air drier.

In the present invention, after forming an overcoat layer by applying overcoat layer coating to the photosensitive layer by a coater, at least one drying condition of the temperature, the speed and the dew point of the drying air and the drying time in the hot air drier is adjusted so that the crystallization degree of the overcoat layer is set to 0.2 to 0.5.

Herein, when D 1145 is an absorbance at 1145 $cm^{-1}$ which is absorption by an OH group forming a hydrogen bond and D1095 is an absorbance at 1095 $cm^{-1}$ which is absorption by stretching of a CO group and bending of an OH group according to infrared absorption spectroscopy, the crystallization degree (A) is represented by the following formula

[Equation 1]

$$A = \frac{0.77}{(D1095/D1145) + 0.3}$$

Since the crystallization degree of the water-soluble polymer of the overcoat layer is controlled in this way, the stability of sensitivity and plate wearing, failure due to residual film and transferability in a platesetter, which have influence on the quality of photopolymerizable lithographic plates, can be improved. This is because when the crystallization degree is less than 0.2, the transferability in a platesetter, failure due to excessive film loss and failure due to minute residual film cannot be improved, and when it is more than 0.5, the stability of sensitivity and plate wearing, failure due to defective development such as residual film and residual color cannot be improved.

From the finding that the crystallization degree of the overcoat layer can be changed depending on the drying condition such as the temperature, the speed and the dew point of drying air and the drying time for drying the overcoat layer, these drying conditions are controlled, whereby the crystallization degree can be set to the range of 0.2 to 0.5. Accordingly, as an apparatus for controlling the crystallization degree of the overcoat layer, for example, the hot air drier provided at the overcoat layer applying and drying section 24 can be suitably used. The crystallization degree of the support 14 on which the overcoat layer is applied is controlled in the hot air drier and the overcoat layer is simultaneously dried. The temperature of the drying air is in the range of 80 to 200°C, preferably a temperature in the range of 100 to 170°C. The speed of the drying air is in the range of 2 to 20 m/second, preferably 2 to 12 m/second. The dew point of the drying air is not more than 25°C, preferably in the range of 10 to 25°C. The drying time is in the range of 20 seconds to 300 seconds, preferably 50 seconds to 200 seconds. In that case, by measuring the crystallization degree of the overcoat layer by an IR apparatus (apparatus for infrared absorption spectroscopy) after controlling the crystallization degree, and then by conducting feed back control of the measured result, the crystallization degree of the overcoat layer can be accurately controlled.

Examples of the water-soluble polymer containing a hydrogen bond forming group contained in the overcoat layer include polyvinyl alcohol, polyvinyl alcohol partially substituted by ester, ether or acetal and a copolymer thereof containing unsubstituted vinyl alcohol units in a substantial amount sufficient for imparting required water solubility. Such polyvinyl alcohol includes those hydrolyzed to an extent of 71 to 100% and having a polymerization degree of 300 to 2400. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-220, PVA-224, PVA-217EE, PVA-217E, PVA-220E, PVA-224E, PVA-405, PVA-420, PVA-613 and L-8 which are available from KURARAY CO., LTD. Examples of the copolymer include polyvinyl acetate chloroacetate or propionate, polyvinyl formal, polyvinyl acetal and copolymers thereof, which are hydrolyzed to an extent of 88 to 100%. Other useful polymers include polyvinyl pyrrolidone, gelatin and gum arabic, which may be used alone or in combination. These water-soluble polymers may be included in a proportion of 30 to 99%, more preferably 50 to 99% based on the total solids of the overcoat layer.

Known additives such as a surfactant for further improving the coatability and a water-soluble plasticizer for improving properties of the coated film may be added to the overcoat layer. Examples of the water-soluble plasticizer include propionamide, cyclohexane diol, glycerin and sorbitol. In addition, water-soluble (meth)acrylic polymer may also be added. The coating amount is preferably about 0.1 $g/m^2$ to about 15 $g/m^2$ based on weight after drying, more preferably about 1.0 $g/m^2$ to about 5.0 $g/m^2$. The coating amount of the overcoat layer after drying is usually 0.5 to 10 $g/m^2$, preferably 1.0 to 5.0 $g/m^2$.

[Control of moisture content of overcoat layer]

The moisture content of the overcoat layer is adjusted to the target moisture content range of 2 to 8% by weight at the humidity-controlled zone for overcoat layer 26. At that time, when it is attempted to control the moisture content of the overcoat layer to the target moisture content range without controlling the crystallization degree of the overcoat layer to 0.2 to 0.5, it was necessary to control the temperature and humidity so that the margin of the change in the temperature and humidity is small at the humidity-controlled zone for overcoat layer 26. However, by controlling the moisture content of the overcoat layer after controlling the crystallization degree of the overcoat layer to the range of 0.2 to 0.5 as in the present invention, the moisture content of the overcoat layer can be set to the target moisture content range even if the margin of the change in the temperature and humidity is great. Accordingly, the influence of the change in the temperature and humidity of the outside air due to the change of season or that due to the weather of the day of manufacture is reduced, and manufacturing control thus becomes easier even without expensive air-conditioning equipment, which is extremely advantageous in view of manufacturing technique. Furthermore, it is easier to correspond to the high speeding of the production line.

This is because the crystallization degree and the moisture content of the overcoat layer are correlated in term of the quality of the photopolymerizable lithographic plate, and it is necessary to appropriately control both the crystallization degree and the moisture content. Specifically, the oxygen permeability of the overcoat layer increases along with the increase of the moisture content of the overcoat layer, while the oxygen permeability of the overcoat layer decreases along with the decrease of the moisture content; as a result, low sensitivity and poor plate wearing are caused along with the increase of the moisture content of the overcoat layer, while a higher sensitivity and a more defective development involving residual film and residual color are caused as the moisture content of the overcoat layer decreases. On the contrary, when the crystallization degree (A) is increased, failure due to slightly excessive film loss or minute residual film caused by a flaw in the overcoat layer is alleviated and high sensitivity and excellent plate wearing are achieved, whereas failure due to defective development such as residual film and residual color tends to occur easily. On the other hand, when the crystallization degree is reduced, failure due to defective development such as residual film and residual color tends to be difficult to occur, but low sensitivity, poor plate wearing and failure due to slightly excessive film loss or minute residual film caused by the flaw tend to occur easily. Accordingly, to produce a photopolymerizable lithographic plate with excellent quality, control of the crystallization degree and the moisture content of the overcoat layer to an appropriate range is important.

The moisture content of the overcoat layer is controlled to the range of 2 to 8% by weight by controlling the temperature and humidity of the humidity-controlled zone for overcoat layer 26 and the time of staying in the humidity-controlled zone 26. The temperature of the humidity-controlled zone 26 is in the range of 15 to 35°C, preferably a temperature in the range of 20 to 30°C. The humidity of the humidity-controlled zone is in the range of 30 to 80%, preferably a humidity in the range of 45 to 70%. The staying time in the humidity-controlled zone is in the range of 30 to 240 seconds, preferably 100 to 200 seconds. In that case, by measuring the moisture content of the overcoat layer by a near infrared detector to conduct feed back control of the measured result, the moisture content can be accurately controlled.

[Take-up of raw continuous sheet of lithographic printing plate]

The thus produced raw continuous sheet 14A of a photopolymerizable lithographic plate is once taken up onto a take-up machine 28 in the form of a roll. By once taking up the raw continuous sheet 14A of the lithographic printing plate to the take-up machine 28, the coil time from the production of the long-sheet raw continuous sheet 14A to the sheet processing step for cutting the raw continuous sheet 14A to the size of the product can be long, and this method is thus more flexible than the method in which production through sheet processing is continuously conducted, and productivity can be improved. However, there is a risk that since the raw continuous sheet 14A is taken up, the overcoat layer may peel off of the photosensitive layer when the raw continuous sheet 14A is rolled out and delivered to the sheet processing step. By controlling the crystallization degree of the overcoat layer to 0.2 to 0.5 as in the present invention, however, the adhesion between the photosensitive layer and the overcoat layer can be improved, and this can avoid the peeling off of the overcoat layer from the photosensitive layer when the raw continuous sheet 14A is rolled out and delivered to the sheet processing step.

[Sheet processing of raw continuous sheet of lithographic printing plate and development]

In the sheet processing step, a protective sheet (slip sheet) is laminated on the overcoat layer and the roll is cut into the size of sheet products by a guillotine and a cutter. In that case, an apparatus for adjusting the moisture content of slip sheet (not shown in the figure) capable of adjusting temperature and humidity is preferably provided in order to set the moisture content of the slip sheet to 2 to 10% by weight, preferably 4 to 6.5% by weight. This is to prevent

the moisture content of the overcoat layer from changing because of lamination of the slip sheet with the photopolymerizable lithographic plate. This can prevent the moisture content of the overcoat layer from going beyond the range of 2 to 8% by weight in sheet processing step, and therefore the quality of the photopolymerizable lithographic plate after production can be maintained well. The moisture content of the slip sheet can be continuously measured using a near infrared detector.

The photosensitive layer of the product of the photopolymerizable lithographic plate processed into sheet is then subjected to imagewise exposure using, for example, a carbon arc lamp, a high-pressure mercury lamp, a xenon lamp, a metal halide lamp, a fluorescent lamp, a tungsten lamp, a halogen lamp, a helium-cadmium laser, an argon ion laser, a FD·YAG laser, a helium-neon laser, a semiconductor laser (350 nm to 600 nm), and a solid laser and a semiconductor laser emitting infrared rays (760 nm to 1200 nm). After imagewise exposure with one of these known active rays, development treatment is conducted to form images on the surface of the aluminum plate support.

After the imagewise exposure, a heating process may be conducted before development at a temperature of 50°C to 150°C for 1 second to 5 minutes for improving the hardening degree of the photopolymerizable photosensitive layer.

As described above, an overcoat layer having an oxygen barrier property is provided on the photosensitive layer of the photosensitive lithographic printing plate according to the present invention. To remove the overcoat layer, a method in which the overcoat layer and unexposed part of the photosensitive layer are simultaneously removed using a developer, and a method in which the overcoat layer is removed first using water or hot water and then the unexposed part of the photosensitive layer is removed by development are known. Water and hot water may contain a preservative described in Japanese Patent Application Laid Open No. 10-10754 or an organic solvent described in Japanese Patent Application Laid Open No. 8-278636.

In the present invention, the photosensitive lithographic printing plate is developed by the above-mentioned developer according to a usual method by, for example, immersing the photosensitive lithographic printing plate which has undergone exposure, and brushing it with a brush in the developer at a temperature of about 0 to 60° C, preferably 15 to 40°C.

When developing using an automatic developing machine, the developer gradually deteriorates in proportion to the amount treated. Developing performance may be therefore refreshed by using a replenishing solution or a fresh developing solution.

The photosensitive lithographic printing plate developed in this manner is further subjected to post-treatments using washing water, a rinsing solution containing a surfactant or a desensitizing solution containing gum Arabic or a starch derivative as described in Japanese Patent Application Laid Open Nos. 54-8002, 55-115045 and 59-58431. These methods may be used in various combinations as the post-treatment of the lithographic printing plate according to the present invention. The plate wearing of the printing plate obtained by the treatments described above can be further improved by a post-exposure treatment according to the method described in Japanese Patent Application Laid Open No. 2000-89478 or a heating treatment such as burning. The lithographic printing plate obtained by these treatments is set up in an offset printing machine to be used for printing of large number of copies.

In the embodiment of the present invention, it is designed that the raw continuous sheet 14A of the photopolymerizable lithographic plate is taken up onto the take-up machine 28 and the raw continuous sheet 14A is then rolled out in the subsequent sheet processing step. However, the method of producing a photopolymerizable lithographic plate of the present invention can be also applied to the case in which production and sheet processing of the raw continuous sheet 14A are successively conducted.

The above-described effects of the control of the crystallization degree and the moisture content of the overcoat layer according to the present invention can be summarized as in the following items.

(1) The sensitivity of the photopolymerizable lithographic plate becomes stable. Consequently, flare and ghost due to scattered light from the laser exposure apparatus are not generated, entanglement is improved and loss of thin line is reduced.
(2) The plate wearing of the photopolymerizable lithographic plate becomes stable.
(3) Occurrence of failure due to defective development (residual film and residual color) of the photopolymerizable lithographic plate is prevented.
(4) Failure due to slightly excessive film loss and failure due to minute residual film caused by a flaw in the overcoat layer of the photopolymerizable lithographic plate are prevented.
(5) The allowable range of the temperature and humidity in the humidity-controlled zone for setting the moisture content of the overcoat layer to the target moisture content range can be extended. Accordingly, expensive air-conditioning equipment is not necessary and even in the case of increased production speed, lithographic printing plates with stable quality can be produced.
(6) Transfer of the overcoat layer to the production roll is prevented and the line stop time for roll cleaning is cut to improve productivity.

(7) Due to improvement in the adhesion between the photosensitive layer and the overcoat layer, the overcoat layer is difficult to be peeled off of the photosensitive layer even if the raw continuous sheet of the lithographic printing plate is once taken up onto a take-up machine and rolled out to be delivered to the sheet processing step, thereby preventing occurrence of failure of bleaching. Accordingly, the time from taking up to sheet processing can be extended and the productivity is increased.

(8) Due to reduced adhesion between the slip sheet and the overcoat layer, the trouble of introduction of the slip sheet into the laser exposure section or the developing section can be prevented upon slip sheet removal at the platesetter.

Examples

Hereinafter, the present invention will be described by means of Examples, but the present invention is not limited to these Examples.

(Example 1)

[Production of photopolymerizable lithographic plate]

An aluminum coil obtained by winding a 0.30-mm thick web aluminum plate 14 (support) of material IS into a roll (coil) is set on a feeder 12. After immersing the aluminum plate 14 continuously delivered from the feeder 12 in 10% sodium hydroxide at 70°C for 60 seconds at the surface-treatment section 16 to conduct etching, the plate was washed with running water, neutralized and cleaned with 20% $HNO_3$ and washed with water. This was then subjected to electrolytic surface roughening treatment in an aqueous 1 % nitric acid solution using an alternate current with a sinusoidal waveform at an anode time electricity of 300 coulomb/$dm^2$ under a condition of VA= 12.7 V. The surface roughness was measured and found to be 0.45 μm (Ra indication). Subsequently, the plate was immersed in an aqueous 30% $H_2SO_4$ solution to conduct desmutting at 55°C for 2 minutes, and with placing a cathode on the grained surface, the plate was anodized in an aqueous 20% $H_2SO_4$ solution at 33°C for 50 seconds with a current density of 5 A/$dm^2$. As a result, the thickness was 2.7 g/$m^2$. The amount of the anodized oxide film on the back of the aluminum plate 14 was about 0.5 g/$m^2$ at the central part and about 1.0 g/$m^2$ on the periphery. The following sol-gel reaction mixture was applied to the back of the thus-treated aluminum plate 14 at the back coat layer applying and drying section 18, and dried until the temperature of aluminum reached 60°C to prepare a support 14 with a back coat layer having a coating amount of 50 mg/$m^2$ after drying.

(Sol-gel reaction mixture)

| | |
|---|---|
| Tetraethyl silicate | 50 parts by weight |
| Water | 20 parts by weight |
| Methanol | 10 parts by weight |
| Phosphoric acid | 0.07 part by weight |

Upon mixing and stirring the above components, heat was generated in about 5 minutes. After reacting for 30 minutes, the following liquid was added thereto to prepare back coat layer coating.

| | |
|---|---|
| Pyrogallol formaldehyde condensation resin (MW2000) | 4 parts by weight |
| Dimethyl phthalate | 5 parts by weight |
| Methanol | 1000 parts by weight |

At the base coat applying and drying section 20, a base coat layer was formed on the aluminum plate to which the back coat layer coating prepared in such manner was applied according to the following procedure. The following coating composition for base coat was mixed and stirred at 30°C. Heat was generated in about 5 minutes and after reacting for 60 minutes, the content was poured to another container and 10,000 parts by weight of methanol was further added thereto to prepare base coat coating.

(Liquid composition for base coat)

| | |
|---|---|
| Compound of formula (2) | 96 parts by weight |
| Methanol | 100 parts by weight |
| Water | 14 parts by weight |
| Phosphoric acid (85% aqueous solution) | 11 parts by weight |
| Tetraethoxysilane | 36 parts by weight |
| 3-methacryloxypropyltrimethoxysilane | 50 parts by weight |

[Formula 1]

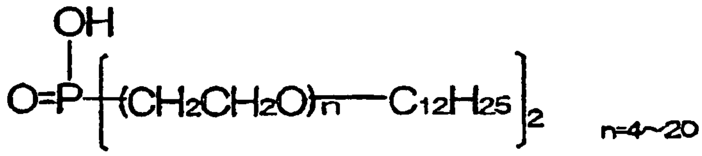

The liquid coating was applied to the aluminum plate 14 treated as above in an amount of 0.1 g/m$^2$, and after drying until the temperature of aluminum reached 70°C, the plate was cooled until the temperature of aluminum reached 50°C or lower.

On the base coat layer obtained in this manner, a high sensitivity photopolymerizable composition having the following composition was applied in a dry weight of coating of 1.4 g/m$^2$ at the photosensitive layer applying and drying section 22. The layer was dried until the temperature of aluminum reached 100°C and then cooled until the temperature of aluminum reached 50°C or less.

(Photopolymerizable composition)

Compound containing ethylenically unsaturated bond (the following A1)

| | |
|---|---|
| | 2.0 parts by weight |
| Linear organic high molecular polymer (the following B1) | 2.0 parts by weight |
| Sensitizer (the following C1) | 0.2 part by weight |
| Photopolymerization initiator (the following D1) | 0.2 part by weight |
| Co-sensitizer (the following E1) | 0.3 part by weight |
| E -phthalocyanine (the following F1) dispersion | 0.02 part by weight |
| Fluorine nonionic surfactant Megafac F176 (available from DAINIPPON INK AND CHEMICALS, INCORPORATED) | 0.03 part by weight |
| Methyl ethyl ketone | 10.0 parts by weight |
| Propylene glycol monoethyl ether acetate | 10.0 parts by weight |

[Formula 2]

A1

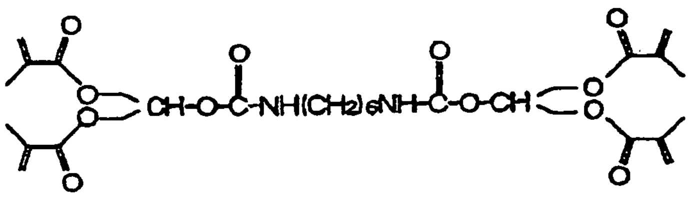

[Formula 3]

B1 MDI/HMDI/DMPA/PPG1000= 80/20/77/23 Molecular weight Mw=60000

MDI

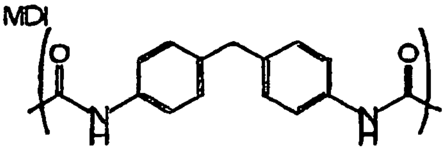

DMPA

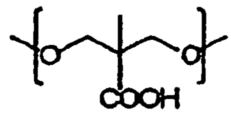

HMDI

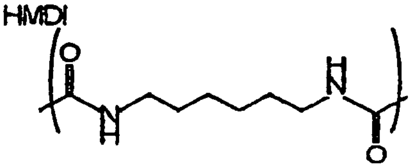

PPG1000(Mw 1000)

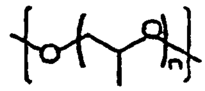

n≒17

[Formula 4]

C1

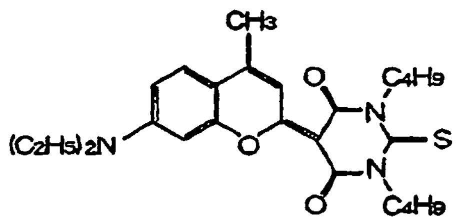

[Formula 5]

D1

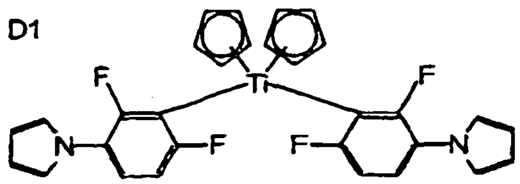

[Formula 6]

E1

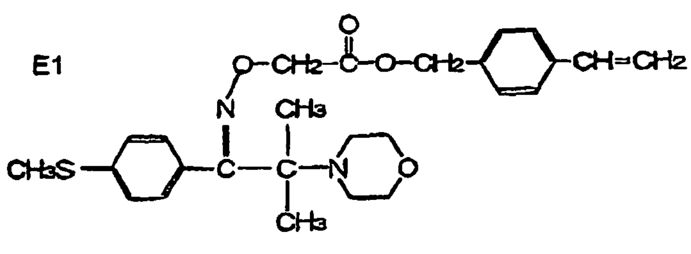

[Formula 7]

F1

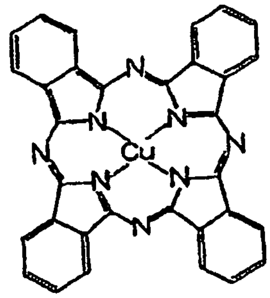

An overcoat layer having the following composition was applied to the photosensitive layer in a dry weight of coating of 2.5 g/$m^2$ at the overcoat applying section. By spraying drying air of a temperature of 150°C and a dew point of 16°C at a speed of 8 m/sec for 1 minute at the drying section 24, the layer was dried so that the crystallization degree of polyvinyl alcohol is 0.45, and the layer was cooled until the temperature of aluminum reached 50°C or less.

(Overcoat liquid composition)

| | |
|---|---|
| Polyvinyl alcohol<br>(available form KURARAY CO. LTD., PVA105, saponification degree 98% by mole, polymerization degree 500) | 20 parts by weight |
| Polyvinyl pyrrolidone K30 (available from Wako Pure Chemical Industries, Ltd.) | 2 parts by weight |
| Nonionic surfactant (EMALEXNP-10 available from Nihon Emulsion Co., Ltd.) | 0.5 part by weight |
| Distilled water | 360 parts by weight |

The aluminum plate 14 to which an overcoat layer was applied and which was dried and then cooled was passed through the humidity-controlled zone for overcoat layer 26 at which the temperature and the humidity were controlled to 25°C and 55% in about 3 minutes to set the moisture content of the overcoat layer to 4.0%, and the aluminum plate was then taken up onto the take-up machine 28. The moisture content of the overcoat layer was measured by an infrared radiation thermometer 31 (made by CHINO Corporation, IRM-V), and with conducting feedback control based on the measurement result, the moisture content was controlled so as not to go beyond 4.0%. Specifically, the air-conditioning unit 32 of the humidity-controlled zone for overcoat layer 26 identifies the kind of the lithographic printing plate to be produced based on the information from a process computer for managing the entire production line, and depending on the kind of the lithographic printing plate and the speed of production, the target moisture content preset in a data table is read, and at the same time, the moisture content of the overcoat layer which was subjected to measurement is measured at a pre-determined intervals using the infrared radiation thermometer 31. The temperature and the humidity of the humidity-controlled zone for overcoat layer 26 are controlled according to these moisture content data. The raw continuous sheet 14A of the lithographic printing plate was produced in this manner.

Then, in the sheet processing step, the raw continuous sheet 14A of the lithographic printing plate was rolled out, the slip sheet described below was laminated thereon, and the roll was then cut into the size of the product using a guillotine and a cutter to obtain sheet-shaped photopolymerizable lithographic plates.

(Preparation of slip sheet)

Bleached kraft pulp was beat to be diluted to a concentration of 4%. To the paper stock was added 0.4% by mass of a synthetic sizing agent, and aluminum sulfate was added thereto so that the pH reached 5.0. 3.0% by mass of a paper strength agent containing starch as a main component was applied to the paper stock, and paper making was conducted to prepare a 38 g/$m^2$ slip sheet having a density of 0.75 g/$m^2$, a smoothness of 25 seconds and a moisture content of 6.0% by mass.

(Method of measuring crystallization degree of overcoat layer)

The overcoat layer of the photopolymerizable lithographic plate produced by the above method was peeled using scotch tape and IR analysis was conducted using a Fourier transform infrared spectrophotometer (made by BIO-RAD Laboratories, Inc., FTS 6000 SPECTROMETER). The crystallization degree of the overcoat layer was calculated based on the absorbances at 1145 $cm^{-1}$ (OH band indicating crystallinity) and 1095 $cm^{-1}$ (CO stretching band, OH bending band) of the IR values obtained, using the formula described in the section of the formation of the overcoat layer (Nagai, Koka, 12, 199, (1995)).

(Method of measuring moisture content of overcoat layer upon take-up)

Water absorption of the photopolymerizable lithographic plate of which the moisture content of the overcoat layer was adjusted in a constant temperature and humidity chamber was measured by an infrared radiation thermometer 31 (made by CHINO Corporation, IRM-V) to draw an calibration curve. Based on this calibration curve and using the absorbance of water measured by the infrared radiation thermometer placed before take-up, the moisture content of the overcoat layer upon take-up was measured. The moisture content of the overcoat layer of the lithographic printing plate for drawing the calibration curve can be measured from the difference in weights before and after drying the overcoat layer.

The photopolymerizable lithographic plate was subjected to imagewise exposure - using a FDYAG laser (made by Fuji Photo Film, Co., Ltd., Luxel PlateSetter P-9600CTP NEW S532nm) under conditions of an exposure of 200 $\mu J/cm^2$, a resolution of 909 dpi (358 dot per cm) and 100 lines/inch (39 lines/cm). The plate was then subjected to post-heating treatment using an automatic developing machine FLP125NFS made by Fuji Photo Film, Co., Ltd., and washed with water, and standard treatment was conducted using a developer DV-2 (available from Fuji Photo Film, Co., Ltd., DV-2:water=1:4) and a finishing gum solution FP-3W (available from Fuji Photo Film, Co., Ltd., FP-3W:water =1:1). The temperature of the developer was 25°C and the time for immersion in the developer was about 22 seconds.

(Example 2)

A photopolymerizable lithographic plate was produced in the same manner as in Example 1 except that the temperature of the air for drying the overcoat layer in Example 1 was raised to 200°C so as to set the crystallization degree of the overcoat layer to 0.5.

(Example 3)

A photopolymerizable lithographic plate was produced in the same manner as in Example 1 except that the temperature of the air for drying the overcoat layer in Example 1 was lowered to 100°C so as to set the crystallization degree of the overcoat layer to 0.2.

(Example 4)

A photopolymerizable lithographic plate was produced in the same manner as in Example 1 except that the temperature and humidity in the humidity-controlled zone for overcoat layer 26 was changed to 25°C and 45 % so as to set the crystallization degree of the overcoat layer to 0.2 and the moisture content of the overcoat layer to 2.0%.

(Example 5)

A photopolymerizable lithographic plate was produced in the same manner as in Example 1 except that the temperature and humidity in the humidity-controlled zone for overcoat layer 26 was changed to 25°C and 70% so as to set the crystallization degree of the overcoat layer to 0.5 and the moisture content of the overcoat layer to 8.0%.

(Comparative Example 1)

A photopolymerizable lithographic plate was produced in the same manner as in Example 1 except that the temperature of the air for drying the overcoat layer in Example 1 was raised to 170°C so as to set the crystallization degree of the overcoat layer to 0.6.

(Comparative Example 2)

A photopolymerizable lithographic plate was produced in the same manner as in Example 1 except that the

temperature of the air for drying the overcoat layer in Example 1 was lowered to 75°C so as to set the crystallization degree of the overcoat layer to 0.1.

Regarding the above Examples 1 to 5 and Comparative Examples 1 and 2, evaluation of developing property, sensitivity for 50 percent dot area, plate wearing, failure in the image portions due to excessive film loss, failure in the non-image portions due to minute residual film and transferability in a platesetter was conducted.

For evaluating the developing property, the non-image portions and the halftone portions of the printing plate and the periphery of the solid image after development were visually observed, and the developing property was determined based on the presence or absence of residual film of the photosensitive layer and the degree of residual film. "B" means "passed", while "F" means "failed".

The 50 percent dot area was measured using a Macbeth RD920 reflection densitometer.

The plate wearing property was evaluated by printing using a newspaper press made by Tokyo Kikai Seisakusho and black news ink available from Dainippon Ink & Chemicals, Inc. For evaluation, the number of copies at which plate wearing of the solid image occurred was defined as the plate wearing. The greater the number of copies, the better the plate wearing.

The failure of the solid image due to excessive film loss was evaluated by conducting exposure on the whole area according to the above-mentioned method, followed by development and observing the number of excessive film loss per 1 $m^2$.

The failure due to minute residual film at the non-image portions was evaluated by developing without exposure and observing the number of minute residual films per 1 $m^2$. "B" means "passed", while "F" means "failed".

The transferability in a platesetter was evaluated by continuously processing 150 plates using P-9600 CTP NEWS Platesetter. The case in which even only 1 plate could not be properly transferred was described as "failed" and the case in which all 150 plates could be transferred without any problem was described as "passed".

The results are shown in Table 1.

[Table 1]

| | Crystallization degree | Moisture content of overcoat layer | Developing property | Sensitivity for 50 percent dot area | Plate wearing | Failure due to excessive loss | Failure due to minute residual film | Transferability in a platesetter (number of plates having trouble) |
|---|---|---|---|---|---|---|---|---|
| Example 1 | 0.45 | 4.0 % | B | 60 % | 200,000copies | 0 piece | 0 piece | 0 plate |
| Example 2 | 0.50 | 4.0 % | B | 60 % | 200,000 copies | 0 piece | 0 piece | 0 plate |
| Example 3 | 0.20 | 4.0% | B | 60 % | 200,000 copies | 0 piece | 0 piece | 0 plate |
| Example 4 | 0.20 | 2.0% | B | 60% | 200,000 copies | 0 piece | 0 piece | 0 plate |
| Example 5 | 0.50 | 8.0% | B | 60 % | 200,000 copies | 0 piece | 0 piece | 0 plate |
| Comparative Example 1 | 0.60 | 4.0% | F | 70% | 250,000 copies | 0 piece | 5 pieces or more | 0 plate |
| Comparative Example 2 | 0.10 | 4.0% | B | 50 % | 100,000 | 5 pieces or more | 0 piece | 10 plates or more |

As is evident from the results in Table 1, Examples 1, 2 and 3 in which the moisture content of the overcoat layer containing as a main component a water-soluble polymer containing a hydrogen bond forming group was set to a constant value of 4.0% by weight and the crystallization degree thereof was controlled to 0.45, 0.50 and 0.20 which satisfy the range of 0.2 to 0.5, marked "passed" for all the quality evaluation items of the developing property, the sensitivity for 50 percent dot area, the plate wearing, the failure due to excessive film loss, the failure due to minute residual film and the transferability in a platesetter.

On the other hand, in Comparative Example 1 in which the moisture content of the overcoat layer was set to a constant value of 4.0% by weight and the crystallization degree thereof was controlled to 0.60 which is beyond 0.50, the plate wearing property was superior to those of Examples, but the developing property and the failure due to minute residual film marked "failed". In addition, in Comparative Example 2 in which the moisture content of the overcoat layer was set to a constant value of 4.0% by weight and the crystallization degree thereof was controlled to 0.10 which is below 0.20, the dot area sensitivity and the plate wearing were inferior to those of Examples and the failure due to excessive film loss and the transferability in a platesetter marked "failed".

From these results, in order to score "passed" for all of the quality evaluation items of the developing property, the sensitivity for 50 percent dot area, the plate wearing, the failure due to excessive film loss, the failure due to minute residual film and the transferability in a platesetter, the crystallization degree must be set to the range of 0.2 to 0.5.

Further, Examples 4 and 5 in which the crystallization degree of the overcoat layer was controlled to 0.2 to 0.5 and the moisture content thereof was controlled to 2% by weight or 8% by weight, marked "passed" for all of the quality evaluation items of the developing property, the sensitivity for 50 percent dot area, the plate wearing, the failure due to excessive film loss, the failure due to minute residual film and the transferability in a platesetter. This suggests that the range of the moisture content can be extended to 2 to 8% by weight from 4 to 7% by weight which is the critical range for controlling the moisture content without consideration of the crystallization degree of the overcoat layer as in Japanese Patent Application Laid Open No. 2001-33975.

In addition, when the crystallization degree of the overcoat layer was controlled to the range of 0.2 to 0.5 at the overcoat layer applying and drying section 24 and then the moisture content of the overcoat layer was controlled to 2 to 8 % by weight at the humidity-controlled zone for overcoat layer 26, the moisture content could be controlled to 2 to 8% by weight even if the margin of the temperature (25°C±2.5°C) and the margin of the humidity (55 % ± 5%) were increased in the humidity-controlled zone 26.

On the contrary, when the crystallization degree of the overcoat layer was controlled beyond the range of 0.2 to 0.5 at the overcoat layer applying and drying section 24 and then the moisture content of the overcoat layer was controlled to 2 to 8% by weight at the humidity-controlled zone for overcoat layer 26, the moisture content could be controlled to 2 to 8% by weight only when the margin of the temperature (25°C ± 1°C) and the margin of the humidity (55% ± 2%) were reduced in the humidity-controlled zone 26.

## Claims

1. A method of producing a photopolymerizable lithographic plate having an overcoat layer containing, as a main component, a water-soluble polymer containing a hydrogen bond forming group, **characterized in that**:

   the crystallization degree (A) of the water-soluble polymer of the overcoat layer is controlled in a range of 0.2 to 0.5, wherein the crystallization degree (A) is represented by the following formula

   [Equation 1]

   $$A = \frac{0.77}{(D1095 / D1145) + 0.3}$$

   in which D1145 is an absorbance at 1145 $cm^{-1}$ which indicates absorption by an OH group having formed a hydrogen bond and D1095 is an absorbance at 1095 $cm^{-1}$ which indicates absorption caused by stretching of a CO group and bending of an OH group in infrared absorption spectroscopy.

2. The method of producing a photopolymerizable lithographic plate according to claim 1, further comprising, after controlling the crystallization degree, controlling the moisture content of the overcoat layer in a target moisture content range from 2 to 8% by weight based on the total amount of solid components of the overcoat layer.

**3.** The method of producing a photopolymerizable lithographic plate according to claim 1 or 2, wherein the crystallization degree is controlled by adjusting at least one drying condition selected from the group consisting of the temperature, speed, dew point of drying air and drying time where the drying air is used to dry the overcoat layer.

**4.** The method of producing a photopolymerizable lithographic plate according to any one of claims 1 to 3, further comprising taking up a web-like raw continuous sheet for the produced photopolymerizable lithographic plate on a take-up machine before said raw sheet is used.

**5.** The method of producing a photopolymerizable lithographic plate according to any one of claims 1 to 4, further comprising a sheet processing step for cutting the web-like raw continuous sheet for the produced photopolymerizable lithographic plate into a cut sheet using a guillotine and a cutter after a slip sheet is laminated on the overcoat layer.

**6.** Photopolymerizable lithographic plate obtainable by the method specified in one or more of claims 1 to 5.

**Patentansprüche**

**1.** Verfahren zur Herstellung einer fotopolymerisierbaren Lithografieplatte, die eine Überzugsschicht aufweist, die als eine Hauptkomponente ein wasserlösliches Polymer enthält, welches eine Wasserstoffbrückenbindungen bildende Gruppe enthält, **dadurch gekennzeichnet, dass**:

der Kristallisationsgrad (A) des wasserlöslichen Polymers der Überzugsschicht im Bereich von 0,2 bis 0,5 eingestellt wird,
worin der Kristallisationsgrad (A) dargestellt ist durch die folgende Formel

[Gleichung 1]

$$A = \frac{0{,}77}{(D1095/D1145)+0{,}3}$$

worin D1145 das Absorptionsvermögen bei 1.145 $cm^{-1}$ ist, welches eine Absorption durch eine OH-Gruppe, die eine Wasserstoffbrückenbindung gebildet hat, anzeigt und D1095 das Absorptionsvermögen bei 1.095 $cm^{-1}$ ist, welches eine Absorption anzeigt, die durch das Strecken einer CO-Gruppe und das Biegen einer OH-Gruppe verursacht wird, in der Infrarot-Absorptionsspektroskopie.

**2.** Verfahren zur Herstellung einer fotopolymerisierbaren Lithografieplatte gemäß Anspruch 1, ferner umfassend, nach dem Einstellen des Kristallisationsgrads, das Einstellen des Feuchtigkeitsgehalts der Überzugsschicht in einem Ziel-Feuchtigkeitsgehaltsbereich von 2 bis 8 Gew.%, bezogen auf die Gesamtmenge von festen Komponenten der Überzugsschicht.

**3.** Verfahren zur Herstelllung einer fotopolymerisierbaren Lithografieplatte gemäß Anspruch 1 oder 2, worin der Kristallisationsgrad durch Einstellen von mindestens einer Trocknungsbedingung kontrolliert wird, ausgewählt aus der Gruppe bestehend aus der Temperatur, der Geschwindigkeit, dem Taupunkt der Trocknungsluft und der Trocknungszeit, wobei die Trocknungsluft verwendet wird, um die Überzugsschicht zu trocknen.

**4.** Verfahren zur Herstelllung einer fotopolymerisierbaren Lithografieplatte gemäß irgendeinem der Ansprüche 1 bis 3, ferner umfassend das Aufnehmen eines bahnartigen, kontinuierlichen Rohblattes für die hergestellte fotopolymerisierbare Lithografieplatte auf einer Aufnahmemaschine bevor das Rohblatt verwendet wird.

**5.** Verfahren zur Herstelllung einer fotopolymerisierbaren Lithografieplatte gemäß irgendeinem der Ansprüche 1 bis 4, ferner umfassend einen Blatt-Verarbeitungsschritt zum Schneiden des bahnartigen, kontinuierlichen Rohblattes für die hergestellte fotopolymerisierbare Lithografieplatte in ein geschnittenes Blatt unter Verwendung einer Papierschneidemaschine und einer Schneidvorrichtung, nachdem ein Gleitblatt auf die Überzugsschicht laminiert ist.

**6.** Fotopolymerisierbare Lithografieplatte, erhältlich durch das Verfahren, wie es in einem oder mehr der Ansprüche 1 bis 5 spezifiziert ist.

## Revendications

**1.** Procédé de production d'une plaque lithographique photopolymérisable ayant une couche de revêtement contenant, en tant que composant principal, un polymère hydrosoluble contenant un groupe de formation de liaison hydrogène, **caractérisé en ce que** :

le degré de cristallisation (A) du polymère hydrosoluble de la couche de revêtement est commandé dans une plage de 0,2 à 0,5,
dans lequel le degré de cristallisation (A) est représenté par la formule suivante

[Équation 1]

$$A = \frac{0.77}{(D1095/D1145)+0.3}$$

dans laquelle D1145 est une absorbance à 1145 $cm^{-1}$ qui indique une absorption par un groupe OH ayant formé une liaison hydrogène et D1095 est une absorbance à 1095 $cm^{-1}$ qui indique une absorption causée par l'étirement d'un groupe CO et le pliage d'un groupe OH dans une spectroscopie par absorption d'infrarouge.

**2.** Procédé de production d'une plaque lithographique photopolymérisable selon la revendication 1, comprenant en outre, après la commande du degré de cristallisation, la commande de la teneur en humidité de la couche de revêtement dans une plage de teneurs en humidité cible de 2 à 8 % en poids sur base de la quantité totale de composants solides de la couche de revêtement.

**3.** Procédé de production d'une plaque lithographique photopolymérisable selon la revendication 1 ou 2,
dans lequel le degré de cristallisation est commandé en ajustant au moins une condition de séchage sélectionnée à partir du groupe constitué par la température, la vitesse, le point de rosée de l'air de séchage et le temps de séchage pendant lequel l'air de séchage est utilisé pour sécher la couche de revêtement.

**4.** Procédé de production d'une plaque lithographique photopolymérisable selon l'une quelconque des revendications 1 à 3,
comprenant en outre l'enroulement d'une feuille continue brute semblable à une bobine pour la plaque lithographique photopolymérisable produite sur une machine d'enroulage avant que ladite feuille brute ne soit utilisée.

**5.** Procédé de production d'une plaque lithographique photopolymérisable selon l'une quelconque des revendications 1 à 4,
comprenant en outre une étape de traitement de feuille pour couper la feuille continue brute semblable à une bobine pour la plaque lithographique photopolymérisable produite en une feuille coupée en utilisant une guillotine et un dispositif de coupe après qu'un papier intercalaire est stratifié sur la couche de revêtement.

**6.** Plaque lithographique photopolymérisable qui peut être obtenue par le procédé spécifié dans une ou plusieurs des revendications 1 à 5.

FIG. 1

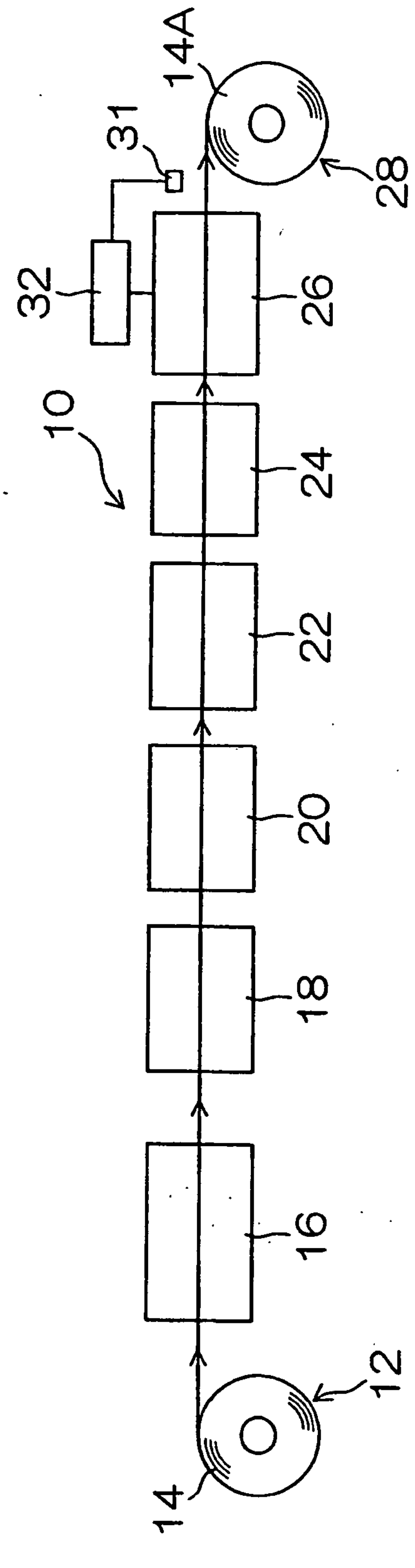

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2001033975 A
- EP 1450207 A1
- US 20030008239 A1
- US 3834398 A
- JP 57016918 A
- JP 50040047 A
- JP 6135175 A
- JP 1141094 A
- JP 6205657 A
- JP 61019115 A
- JP 57044760 A
- JP 5019300 A
- JP 5195300 A
- JP 6037716 A
- US 2714066 A
- US 3181461 A
- US 3280734 A
- US 3902734 A
- JP 3622063 B
- US 3276868 A
- US 4153461 A
- US 4689272 A
- JP 62251739 A
- JP 6242597 A
- JP 48041708 A
- JP 51037193 A
- JP 2032293 A
- JP 48064183 A
- JP 49043191 A
- JP 52030490 A
- US 2850445 A
- JP 4420189 B
- JP 4537377 B
- JP 47002528 A
- JP 54155292 A
- JP 48084183 A
- JP 54151024 A
- JP 52112681 A
- JP 58015503 A
- JP 59140203 A
- JP 59001504 A
- JP 59189340 A
- JP 62174203 A
- JP 62001641 A
- US 4766055 A
- JP 63258903 A
- JP 2063054 A
- JP 62143044 A
- JP 62150242 A
- JP 6413140 B
- JP 6413141 B
- JP 6413142 B
- JP 6413143 B
- JP 6413144 B
- JP 6417048 B
- JP 1229003 A
- JP 1298348 A
- JP 1138204 A
- JP 2179643 A
- JP 2244050 A
- JP 63221110 A
- JP 4221958 A
- JP 4219756 A
- JP 6295061 A
- JP 8334897 A
- JP 11084647 A
- JP 2000147763 A
- JP 11221480 A
- JP 59152396 A
- JP 61151197 A
- JP 59044615 A
- JP 54034327 A
- JP 58012577 A
- JP 54025957 A
- JP 54092723 A
- JP 59053836 A
- JP 59071048 A
- JP 7120040 A
- JP 7120041 A
- JP 7120042 A
- JP 8012424 A
- JP 63287944 A
- JP 63287947 A
- JP 1271741 A
- JP 11352691 A
- JP 58004589 A
- JP 59123568 A
- JP 4244265 A
- JP 1057629 A
- JP 10128212 A
- JP 6063487 A
- JP 60149871 A
- JP 60021334 A
- JP 10010754 A
- JP 8278636 A
- JP 54008002 A
- JP 55115045 A

- JP 59058431 A
- JP 2000089478 A

**Non-patent literature cited in the description**

- Aluminum Handbook. Japan Light Metal Association, 1990
- **Fujio Mamiya.** *Surface Control,* 1984, 65-72
- *Journal of the Adhesion Society of Japan,* 1984, vol. 20 (7), 300-308